# EUROPÄISCHE PATENTSCHRIFT

(11) **EP 3 271 771 B1**
(45) Veröffentlichungstag und Bekanntmachung des Hinweises auf die Patenterteilung: **24.06.2026**
(21) Anmeldenummer: 16710701.0
(22) Anmeldetag: 11.03.2016
(51) Int. Cl.: G01C 9/06, G02B 26/08, G02B 26/10, H02N 1/00, G01D 5/241, G02B 19/00

(54) **EINRICHTUNG ZUR VERSCHWENKUNG EINES SPIEGEL-ELEMENTS MIT ZWEI SCHWENK-FREIHEITSGRADEN UND SENSOR ZUR BESTIMMUNG DER VERSCHWENKUNG**
DEVICE FOR SWIVELING A MIRROR ELEMENT WITH TWO DEGREES OF SWIVELING FREEDOM AND SENSOR FOR ANALYZING THE SWIVELING
DISPOSITIF POUR FAIRE PIVOTER UN ÉLÉMENT MIROIR AYANT DEUX DEGRÉS DE LIBERTÉ DE PIVOTEMENT ET CAPTEUR PERMETTANT DE DÉTERMINER LE PIVOTEMENT

(30) Priorität: 18.03.2015 DE 102015204874
(43) Veröffentlichungstag der Anmeldung: 24.01.2018
(73) Patentinhaber: Carl Zeiss SMT GmbH, 73447 Oberkochen (DE)
(72) Erfinder: HAUF, Markus, 89075 Ulm (DE); SAROV, Yanko, 73431 Aalen (DE)
(74) Vertreter: Rau, Schneck & Hübner Patentanwälte Rechtsanwälte PartGmbB
(86) Internationale Anmeldenummer: PCT/EP2016/055351
(87) Internationale Veröffentlichungsnummer: WO 2016/146541

(56) Entgegenhaltungen:
- DE-A1- 102012 218 219
- DE-A1- 102012 218 219
- DE-A1- 102012 218 219
- FR-A1- 2 865 201
- FR-A1- 2 865 201
- US-A1- 2001 034 938
- US-A1- 2005 236 928
- US-A1- 2005 236 928
- US-A1- 2011 080 627
- US-A1- 2011 080 627
- WANG YU ET AL: "A novel 2-dimensional electric field sensor based on in-plane micro rotary actuator", IEEE SENSORS 2014 PROCEEDINGS, IEEE, 2 November 2014 (2014-11-02), pages 1924 - 1927, XP032705344, DOI: 10.1109/ICSENS.2014.6985407
- WANG YU ET AL: "A novel 2-dimensional electric field sensor based on in-plane micro rotary actuator", IEEE SENSORS 2014 PROCEEDINGS, IEEE, 2 November 2014 (2014-11-02), pages 1924 - 1927, XP032705344, DOI: 10.1109/ICSENS.2014.6985407
- JINGYAN DONG ET AL: "Simultaneous actuation and displacement sensing for electrostatic drives", JOURNAL OF MICROMECHANICS AND MICROENGINEERING, vol. 18, no. 3, 1 March 2008 (2008-03-01), pages 035011, XP055059814, ISSN: 0960-1317, DOI: 10.1088/0960-1317/18/3/035011
- HOLMSTROM SVEN T S ET AL: "MEMS Laser Scanners: A Review", JOURNAL OF MICROELECTROMECHANICAL SYSTEMS, IEEE SERVICE CENTER, US, vol. 23, no. 2, 1 April 2014 (2014-04-01), pages 259 - 275, XP011544460, ISSN: 1057-7157, [retrieved on 20140331], DOI: 10.1109/JMEMS.2013.2295470
- WANG YU ET AL: "A novel 2-dimensional electric field sensor based on in-plane micro rotary actuator", IEEE SENSORS 2014 PROCEEDINGS, IEEE, 2 November 2014 (2014-11-02), pages 1924 - 1927, XP032705344, DOI: 10.1109/ICSENS.2014.6985407

## Beschreibung

Die vorliegende Patentanmeldung nimmt die Priorität der deutschen Patentanmeldung DE 10 2015 204 874.8 in Anspruch.

Die Erfindung betrifft eine Sensor-Einrichtung zur Erfassung der Verschwenkposition eines Spiegel-Elements. Die Erfindung betrifft außerdem eine Einrichtung zur Verschwenkung eines Spiegel-Elements mit zwei Schwenk-Freiheitsgraden. Weiterhin betrifft die Erfindung ein optisches Bauelement sowie ein Spiegel-Array mit einer Mehrzahl derartiger optischer Bauelemente. Außerdem betrifft die Erfindung eine Beleuchtungsoptik und ein Beleuchtungssystem für eine Projektionsbelichtungsanlage sowie eine Projektionsbelichtungsanlage.

Ein Spiegel-Array mit einer Vielzahl von verlagerbaren Einzelspiegeln ist beispielsweise aus der WO 2010/049076 A2 bekannt. Für die optische Funktion und Qualität eines auf derartigen Spiegel-Arrays spielen unter anderem die Eigenschaften der Aktuatoren, welche zur Positionierung der Einzelspiegel dienen, eine entscheidende Rolle. Aktuator-Einrichtungen zur Verlagerung von Einzelspiegeln eines Spiegel-Arrays für eine Projektionsbelichtungsanlage sind aus der DE 10 2013 206 529 A1 und der DE 10 2013 206 531 A1 bekannt.

Eine Aufgabe der Erfindung besteht darin, eine Sensor-Einrichtung zur Erfassung der Verschwenkposition eines Spiegel-Elements zu verbessern.

Diese Aufgabe wir durch eine Sensor-Einrichtung mit einer Sensor-Einheit gelöst, welche eine Sender-Elektrode mit einer Kammstruktur, eine Empfänger-Elektrode mit einer Kammstruktur und eine Spannungsquelle zur Beaufschlagung der Sender-Elektrode mit einer Wechselspannung aufweist.

Die Sensor-Einrichtung ermöglicht insbesondere eine direkte Erfassung der Verschwenkposition eines Spiegel-Elements, welches mit Hilfe einer Verlagerungs-Einrichtung verschwenkt werden kann. Die Sensor-Einrichtung kann ein Bestandteil einer derartigen Verlagerungs-Einrichtung bilden. Jeder der Sensoren der Sensor-Einrichtung misst die Verlagerungsposition des jeweiligen Spiegel-Elements direkt zur Referenzfläche. Hierdurch wird einerseits die Messung an sich vereinfacht, andererseits ermöglicht dies eine höhere Präzision der Messung, da ein Mitlaufen der Achsen, wie es bei einer Seriell-Kinematik notwendig wäre, nicht berücksichtigt werden muss.

Die Sensor-Einrichtung umfasst eine Mehrzahl von differenziellen Sensorpaaren. Sie umfasst insbesondere zwei differenzielle Sensorpaare, deren Messachsen orthogonal zueinander angeordnet sind.

Jedes Sensorpaar definiert eine Messachse, entlang welcher die Verschwenkposition des Spiegel-Elements erfasst wird. Durch Kombination der Messwerte sämtlicher Sensorpaare wird die Kippposition des Spiegel-Elements relativ zur Grundplatte vollständig erfasst.

Unter einem differenziellen Sensorpaar sei hierbei eine Anordnung von zwei Sensoren verstanden, welche aus der Messung zweier Vertikalbewegungen einen Kippwinkel bestimmen. Gleichtaktbewegungen, welche beispielsweise durch eine durch Thermalausdehnung verursachte Vertikalbewegung des Spiegels verursacht werden, tragen aufgrund der Differenzbildung nicht zum Messsignal des gemessenen Spiegelkippwinkels bei. Die differenzielle Sensoranordnung hat somit den Vorteil, dass die Kippposition des Spiegels direkt und vollständig über die Sensorpaare erfasst wird. Sie ist insbesondere in erster Näherung nicht auf die Stabilität des mechanischen Drehpunkts, das heißt des effektiven Schwenkpunkts, angewiesen.

Als differenzielle Sensoren eignen sich longitudinale kapazitive Kammwandler, mit denen über Kapazitätsmessung die Relativposition von einem beweglichen Anker zu einem ortsfesten Stator bestimmt werden kann. Die Kapazitätsmessung solcher Sensoren kann auf zweierlei Arten erfolgen: Entweder wird die Kapazität zwischen den Kammfingern des beweglichen Ankers und denen des ortsfesten Stators gemessen. In diesem Fall hängt die gemessene Kapazität linear vom longitudinalen Überlapp der Kammfinger ab. Alternativ hierzu kann auch die Kapazität zwischen benachbarten Statorkammfingern gemessen werden, wobei die Finger der beweglichen Ankerkämme als variable, positionsabhängige Abschirmung wirken. Diese Alternative wird auch als Abschirm-Modus (Shield Mode) bezeichnet. Auch in diesem Messmodus hängt die gemessene Kapazität linear vom longitudinalen Überlapp der Kammelektroden ab.

Der Abschirmmodus hat den Vorteil, unempfindlicher gegenüber einer parasitären Bewegung der Kämme relativ zueinander, beispielsweise einer Transversalbewegung und/oder einer Verkippung, zu sein.

Der erste Messmodus ermöglicht eine höhere Empfindlichkeit.

Beide Messmodi sind möglich. Der erste ist aufgrund seiner größeren Empfindlichkeit in Messrichtung vorteilhaft, insbesondere hinsichtlich Sensorrauschen. Der zweite ist aufgrund der geringeren Empfindlichkeit im Hinblick auf eine Parasitätbewegung vorteilhaft im Hinblick auf Linearität und Driftstabilität. Der zweite Modus erlaubt auch größere Fertigungstoleranzen.

Je nach Anforderung kann einer der beiden Messmodi implementiert werden. Es ist auch möglich, beide Messmodi zu kombinieren.

Bei der zweiten Alternative bilden die mit dem Spiegelkörper mechanisch verbundenen Bestandteile der Sensor-Einrichtung eine Abschirm-Einheit. Erfindungsgemäß weist die Abschirm-Einheit weist eine Kammstruktur auf. Sie ist derart relativ zur Sender- und Empfänger-Elektrode der Sensor-Elektrodenstruktur angeordnet, dass eine Abschirmung von beiden durch Eintauchen der Abschirm-Einheit zwischen den Kammstrukturen dieser Elektroden bewirkt wird. Eine derartige Abschirmung ist insbesondere unempfindlich gegen eine Verkippung und/oder Querbewegung der Abschirm-Einheit.

Die Kammstruktur der Sender- und/oder Empfänger-Elektrode umfasst insbesondere radial zum Schwenkpunkt des Spiegel-Elements angeordnete Kammfinger.

Vorzugsweise sind jeweils zwei Sensor-Einheiten differenziell verschaltet. Sie bilden jeweils ein Sensorpaar. Da sich bei der Differenzbildung gemeinsame Fehler aufheben, kann hierdurch der Einfluss von gemeinsamen Longitudinalbewegungen entlang der Kammfinger, verursacht durch parasitäre Vertikalbewegung wie beispielsweise Thermaldrift oder vertikale Schwingungsmoden des Spiegels unterdrückt werden. Des weiteren ist die differentielle Kapazitätsmessung vorteilhaft, um gemeinsame Störeinflüsse und parasitäre Effekte in den Zuleitungen zu unterdrücken.

Gemäß einem Aspekt der Erfindung sind die Sender- und Empfänger-Elektrode jeweils ortsfest, insbesondere ortsfest zueinander angeordnet. Sie können insbesondere auf der Tragestruktur angeordnet sein. Die Sensor-Einrichtung weist insbesondere keine bewegten Signal- und/oder Stromleitungen auf. Eine Anordnung auf der Tragestruktur ermöglicht es insbesondere, die Verschwenkposition des Spiegel-Elements direkt relativ zur Tragestruktur zu erfassen.

Gemäß einem weiteren Aspekt der Erfindung bildet die Sender-Elektrode ein Abschirm-Element, insbesondere gegenüber den Aktuatorelektroden der Verlagerungs-Einrichtung. Sie weist insbesondere einen umfangsseitig geschlossenen Bereich auf. Sie weist insbesondere eine Ausbildung auf, welche die Empfänger-Elektrode in einer Ebene parallel zur Kamm-Ebene vollständig umgibt. Hierdurch kann eine Wechselwirkung der Sensor-Einrichtung mit der Aktuator-Einrichtung reduziert, insbesondere minimiert, insbesondere verhindert werden.

Die Sensor-Einrichtung ist insbesondere in die Verlagerungs-Einrichtung integriert ausgebildet. Sie kann insbesondere einen Bestandteil der Verlagerungs-Einrichtung bilden. Es ist insbesondere möglich, einen Teil der Aktuator-Elektroden durch Elektroden der Sensor-Einheit zu ersetzen oder als Sensor-Elektroden zu nutzen.

Die Sensor-Einheit bildet insbesondere einen kapazitiven Sensor.

Die Sensor-Einrichtung bildet insbesondere einen radialen, differenziellen, kapazitiven Kamm-Sensor, welcher auf dem Prinzip der Abschirmung, insbesondere durch Eintauchen der Abschirm-Einheit zwischen die Sender- und Empfänger-Elektroden beruht. Ein Vorteil einer derartigen Sensor-Einrichtung besteht darin, dass sie im Wesentlichen insensitiv gegen thermische Ausdehnung der Elektroden und/oder der Abschirm-Einheit ist. Sie ist außerdem im Wesentlichen insensitiv gegenüber parasitären Spiegel-Bewegungen.

Entsprechend wie die Aktuator-Elektroden einen Direktantrieb des Spiegel-Elements bilden, ist die Sensor-Einrichtung derart ausgebildet und angeordnet, dass sie direkt zwischen Grundplatte und Spiegel-Element misst. Die Verlagerungsposition des Spiegel-Elements wird insbesondere direkt relativ zur Grundplatte gemessen. Eine Drift, welche beispielsweise durch mechanische Transmissionen von dem Spiegel-Element zu den Sensor-Elektroden verursacht werden kann, wird zuverlässig vermieden. Dies führt zu einer erhöhten Driftstabilität, welche insbesondere bei thermisch belasteten Systemen einen großen Vorteil darstellt.

Eine weitere Aufgabe der vorliegenden Erfindung ist es, eine Einrichtung zur Verschwenkung eines Spiegel-Elements zu verbessern.

Diese Aufgabe wird durch eine Einrichtung zur Verschwenkung eines Spiegel-Elements mit zwei Schwenk-Freiheitsgraden gelöst, welche eine Elektrodenstruktur mit als Kamm-Elektroden ausgebildeten Aktuator-Elektroden und eine Sensor-Einrichtung gemäß der vorhergehenden Beschreibung umfasst, wobei sämtliche aktiven Aktuator-Elektroden in einer einzigen Ebene angeordnet sind, und wobei die Aktuatoren einen Direktantrieb zur Verschwenkung des Spiegel-Elements bilden. Die Aktuator-Elektroden weisen hierbei eine Erstreckung in senkrechter Richtung zu dieser Ebene auf.

Unter einem Direktantrieb sei hierbei ein Antrieb verstanden, bei welchem die Aktuatoren direkt eine Kraft auf den zu verlagernden Spiegel ausüben können. Es wird insbesondere kein Kraft-Transmissionsmechanismus benötigt. Der Antrieb ist mit anderen Worten kraft-transmissionsmechanismus-frei.

Durch ein derartiges Design lässt sich die Verlagerung des Spiegel-Elements verbessern. Unter Verlagerung sei im Folgenden allgemein eine Verlagerung im Hinblick auf einen bestimmten Freiheitsgrad verstanden. Bei der Verlagerung kann es sich insbesondere um eine Verschwenkung, welche auch als Verkippung bezeichnet wird, handeln. Prinzipiell kann die Verlagerung auch lineare Verlagerungen und/oder Verdrehungen des Spiegel-Elements in einer Spiegel-Ebene umfassen.

Es wird insbesondere die Aktuatorcharakteristik verbessert. Die Aktuatorcharakteristik wird insbesondere über einen weiten Bewegungsbereich linearisiert. Es ist insbesondere möglich, die Lagerung des Spiegel-Elements zu vereinfachen. Außerdem weist die Aktuator-Einrichtung verbesserte dynamische Eigenschaften auf.

Erfindungsgemäß wurde erkannt, dass es für eine präzise Einstellung des Kippwinkels des Spiegel-Elements über einen weiten Kippwinkelbereich vorteilhaft ist, wenn die Aktuatoren zur Verlagerung des Spiegel-Elements über einen weiten Kippwinkelbereich arbeiten und hierbei ein lineares oder zumindest weitgehend lineares und deterministisches Verhalten zeigen.

Bislang war man davon ausgegangen, dass Kamm-Elektroden lediglich zur Verschwenkung eines Spiegel-Elements um eine einzige Schwenkachse, das heißt lediglich mit einem Schwenk-Freiheitsgrad, geeignet sind. Um eine Verschwenkung eines Spiegel-Elements mit zwei Schwenk-Freiheitsgraden zu ermöglichen, mussten mehrere Kamm-Elektroden übereinander angeordnet werden. Die Aktuator-Einrichtung hatte in diesem ein gestapeltes Design ("stacked design"), das heißt eine serielle Kinematik.

Es wurde erkannt, dass ein derartiges Design eine komplexe Führungsmechanik notwendig macht.

Weiterhin wurde erkannt, dass ein Nachteil eines derartigen Designs darin besteht, dass die Verdrahtung von einer ortsfesten Grundplatte in einen mitbewegten Aktuatorteil gezogen werden muss, das heißt, dass es bewegte Drähte oder Zuleitungen gibt, und dass die Sensoren nicht direkt vom bewegten Spiegel zur Grundplatte messen, sondern im Allgemeinen nur einen aktuierten Freiheitsgrad auf ihrer jeweiligen Ebene.

Erfindungsgemäß wurde erkannt, dass es möglich ist, eine Elektrodenstruktur mit als Kamm-Elektroden ausgebildeten Aktuator-Elektroden derart auszubilden, dass sämtliche aktiven Aktuator-Elektroden in einer einzigen Ebene angeordnet sind. Unter aktiven Elektroden sind hierbei die Elektroden verstanden, welche zur Verlagerung des Spiegel-Elements mit einer variablen, insbesondere einer steuerbaren, insbesondere regelbaren, Aktuator-Spannung beaufschlagt werden. Elektroden, welche mit einer fixen, das heißt konstanten Spannung beaufschlagt werden, werden auch als passive Elektroden bezeichnet. Die passiven Elektroden können insbesondere geerdet sein, beziehungsweise auf einer Spannung von 0 V gehalten werden.

Die Ebene, in welcher die aktiven Aktuator-Elektroden angeordnet sind, wird auch als Aktuator-Ebene oder Kammebene bezeichnet. Sie ist insbesondere senkrecht zu einer Flächennormalen auf einem zentralen Punkt der Reflexionsfläche des zu verlagernden Spiegel-Elements in unverschwenktem Zustand. Sie ist insbesondere parallel zu den durch die durch die Anordnung der Aktuator-Elektroden definierten Schwenkachsen, um welche das Spiegel-Element verschwenkbar ist, in unverschwenktem Zustand. Die Schwenkachsen sind nicht notwendigerweise durch das mechanische Design der Aktuator-Einrichtung vorgegeben. Es ist insbesondere möglich, durch Kombination zweier Verschwenkungen und linear unabhängige Schwenkachsen eine im Wesentlichen beliebig ausrichtbare effektive Schwenkachse zu erreichen.

Die Schwenkachsen korrespondieren jeweils zu einem der Schwenk-Freiheitsgrade.

Gemäß einem Aspekt der Erfindung werden zwei Schwenkachsen für die Verschwenkung des Spiegel-Elements durch die mechanische Lagerung desselben vorgegeben. Das Spiegel-Element ist insbesondere mittels eines Festkörpergelenks gelagert. Es ist insbesondere mittels eines kardanischen Gelenks gelagert. Durch das Gelenk zur Lagerung des Spiegel-Elements werden zwei mechanische Schwenkachsen vorgegeben. Die beiden durch das Gelenk vorgegebenen mechanischen Schwenkachsen sind insbesondere parallel zur Aktuator-Ebene ausgerichtet. Die beiden Schwenkachsen schneiden sich in einem zentralen Punkt, welcher auch als Schwenkpunkt des Spiegel-Elements bezeichnet wird. Der Schwenkpunkt liegt insbesondere auf der Flächennormalen durch einen zentralen Punkt des Spiegel-Elements in unverschwenktem Zustand.

Das Spiegel-Element ist insbesondere mittels eines zentral angeordneten Festkörpergelenks gelagert.

Das Gelenk weist insbesondere eine Drehsymmetrie, insbesondere eine zweizählige Drehsymmetrie, auf.

Durch die Lagerung des Spiegel-Elements mit einem Festkörpergelenk, insbesondere mit einem kardanischen Festkörpergelenk, werden insbesondere die mechanischen Eigenschaften der Verlagerungs-Einrichtung verbessert. Ein Vorteil der kardanischen Lagerung ist, dass sie große Steifigkeit in den nicht aktuierten Freiheitsgraden ermöglicht und eine geringe Steifigkeit der aktuierten Freiheitsgrade, sodass die Aktuatoren gut geführt werden und eine große Modenseperation zwischen aktutieren und nicht-aktuierten Freiheitsgranden entsteht.

Durch das Gelenk werden zwei Schwenkachsen definiert, welche einen gemeinsamen Schnittpunkt mit einer Flächennormalen durch das Zentrum des der Reflexionsfläche jedes Spiegel-Elements aufweisen. Die verbleibenden Freiheitsgrade werden mit hoher Steifigkeit gefesselt.

Bei dem Gelenk kann es sich insbesondere um ein aus Biege- und/oder Torsionselementen realisiertes kardanisches Festkörpergelenk handeln. Das Gelenk ist vorteilhafterweise in den aktuierten Kippfreiheitsgraden weich und in allen anderen, gefesselten Freiheitsgraden sehr steif, insbesondere mindestens 10mal, insbesondere mindestens 100mal, insbesondere mindestens 1000mal steifer als in den aktuierten Freiheitsgraden.

Das Gelenk kann eine oder mehrere Blattfedern umfassen. Die Blattfedern sind vorteilhafterweise auf eine möglichst gute Wärmeleitfähigkeit ausgelegt. Es konnte gezeigt werden, dass hierbei eine Ausführung des Gelenks als Biegegelenk vorteilhaft ist.

Die Elektrodenstruktur umfasst insbesondere mindestens zwei, insbesondere mindestens drei, insbesondere mindestens vier Kamm-Elektroden. Die Elektrodenstruktur umfasst insbesondere für jeden Freiheitsgrad mindestens zwei Kamm-Elektroden. Hierdurch kann für jeden Freiheitsgrad ein symmetrischer Bewegungsbereich um die Nullposition erreicht werden.

Die Kamm-Elektroden umfassen jeweils eine Mehrzahl von Elektroden-Fingern, welche auch als Kammfinger bezeichnet werden. Die Anzahl der Kammfinger je Kamm-Elektrode liegt insbesondere im Bereich von 3 bis 100, insbesondere im Bereich von 5 bis 50, insbesondere im Bereich von 10 bis 40, insbesondere im Bereich von 20 bis 30. Vorzugsweise umfasst jede der Kamm-Elektroden dieselbe Anzahl an Kammfingern.

Benachbarte Kammfinger weisen jeweils einen Abstand im Bereich von 1 µm bis 10 µm, insbesondere im Bereich von 3 µm bis 7 µm, insbesondere von etwa 5 µm auf. Der Abstand bezeichnet hierbei den lateralen Abstand der mit dem Spiegelkörper mechanisch verbundenen Kammfinger, welche auch als Spiegel-Kammfinger bezeichnet werden, zu den nächstgelegenen mit der Grundplatte mechanisch verbundenen Kammfingern, welche auch als Stator-Kammfinger bezeichnet werden. Der notwendige Abstand wird im Wesentlichen durch die parasitäre Querbewegung der Kammfingervorgegeben. Dieser hängt wiederum vom Kippwinkelbereich, vom Kammüberlapp und von der maximalen radialen Dimension der Kämme ab.

Die angegebenen Abstände beziehen sich auf einen Spiegel mit Abmessungen von etwa 1 mm · 1 mm. Für Spiegel mit anderen Dimensionen und/oder einer alternativen Anordnung der Kammfinger ist vorgesehen, die Abstände entsprechend zu skalieren.

Die Aktuator-Einrichtung umfasst insbesondere jeweils zwei Kamm-Elektroden je Schwenk-Freiheitsgrad. Diese beiden Kamm-Elektroden werden vorzugsweise differenziell angesteuert.

Durch dezidierte Aktuatorpaare für jeden Schwenk-Freiheitsgrad kann die Aktuierung im Hinblick auf die beiden Freiheitsgrade entkoppelt werden. Dies ermöglicht es, das Aktuatorpaar für jeden der Freiheitsgrade sowie dessen Ansteuerung zu optimieren.

Gemäß einem Aspekt der Erfindung weist die Aktuator-Einrichtung eine Parallelkinematik auf. Sie unterscheidet sich somit von Aktuator-Einrichtungen mit einem seriellen kinematischen Konzept, bei welchem für jeden Schwenk-Freiheitsgrad separate Aktuator-Strukturen vorgesehen sind, welche über- bzw. hintereinander angeordnet sind. Bei einer Aktuator-Einrichtung mit einer Parallelkinematik sind die Aktuator-Elektroden für beide Schwenk-Freiheitsgrade äquivalent zueinander ausgebildet. Sie sind insbesondere äquivalent zueinander relativ zu dem zu verschwenkenden Spiegel-Element und zur Grundplatte angeordnet.

Im Gegensatz zu einer Seriell-Kinematik, bei welcher die für eine Verlagerung eines Elements in mehreren Freiheitsgraden vorgesehenen Achsen hintereinander, also seriell, angeordnet sind, und jede Achse für sich alleine angetrieben und gegebenenfalls über einen Sensor und einen Regler geregelt wird, werden bei der erfindungsgemäßen Parallel-Kinematik sämtliche aktuierten Freiheitsgrade direkt von Aktuatoren angetrieben, die das angetriebene Element, das heißt das Spiegel-Element, direkt mit der Referenzfläche, das heißt der Grundfläche, verbinden. Die Aktuatoren sind somit im Sinne des Wirkpfades parallel angeordnet.

Dasselbe gilt für die Sensoren. Während sich bei einer Seriell-Kinematik nur die erste Achse direkt auf die Referenzfläche bezieht und alle weiteren Achsen mitlaufen, misst bei der erfindungsgemäßen Parallelkinematik jeder Sensor direkt vom verlagerbaren Spiegel-Element zur Referenzfläche.

Alle nicht angetriebenen Freiheitsgrade des Spiegel-Elements werden durch Führungen und/oder Gelenke gesperrt.

Die Aktuator-Elektroden sind derart angeordnet, dass sie eine Verkippung des Spiegel-Elements mit zwei Kipp-Freiheitsgraden erlauben, ohne dass es hierbei zu einer Kollision zwischen den Kämmen der Aktuator-Elektroden kommt. Die erfindungsgemäße Ausbildung und Anordnung der Aktuator-Elektroden ermöglicht es, ein weitgehend lineares Aktuatorverhalten über einen Weitenaktuierungsbereich (Aktuierungsrange) zu bekommen. Bislang wurden Kippspiegelantriebe für zwei Kippfreiheitsgrade, welche mit Kammelektroden arbeiten, entweder durch eine Seriell-Kinematik und/oder durch Transmissionsmechanismen realisiert. Es wurde erkannt, dass derartige Mechanismen im Allgemeinen sehr aufwändig herzustellen sind. Sie sind außerdem mit vielen Designkompromissen verbunden. Diese Nachteile werden durch die erfindungsgemäße Ausbildung und Anordnung der Aktuator-Elektroden vermieden.

Die erfindungsgemäße Einrichtung zur Verschwenkung des Spiegel-Elements weist insbesondere einen Kammelektroden-basierten elektrostatischen Direktantrieb des Spiegel-Elements in zwei Freiheitsgraden auf. Durch den Direktantrieb lassen sich parasitäre Resonanzen vermeiden. Es kann eine ideale Kopplungssteifigkeit vom Aktuator zur Grundplatte und zum Spiegel erreicht werden.

Dasselbe gilt für die Sensor-Einrichtung.

Ein sich hieraus ergebender Vorteil ist, dass das Eigenfrequenzspektrum des Spiegel-Elements, welches ein Regler sieht, ausschließlich durch die Lagerung des Spiegel-Elements bestimmt ist, nicht jedoch durch die mechanische Ankopplung von Aktuator und Sensor an das Spiegel-Element. Dies ermöglicht eine regelungstechnisch günstige Aktuator-Sensor-Kollokation, bei welcher die Polstellen der Resonanzen durch Nullstellen getrennt sind und die Phase nicht weiter als 180° dreht.

Vorzugsweise sind sämtliche der Aktuator-Elektroden abgesehen von ihrer Anordnung relativ zum Spiegel-Element identisch ausgebildet.

Gemäß einem weiteren Aspekt der Erfindung weist die Elektrodenstruktur eine Radiärsymmetrie auf. Sie weist insbesondere eine mindestens dreizählige, insbesondere eine mindestens vierzählige Radiärsymmetrie auf. Die Radiärsymmetrie der Elektrodenstruktur kann insbesondere n-zählig sein, wobei n gerade die Anzahl der Kammfinger sämtlicher aktiven Aktuator-Elektroden angibt.

Die Symmetrie der Anordnung kann insbesondere gruppentheoretisch durch die D4-Gruppe beschrieben werden. Sofern die Elektrodenstruktur eine kreisförmige Außenkontur aufweist, kann die Anordnung der Kammfinger auch durch eine Dn-Gruppe beschrieben werden, wobei n die Anzahl der Kammfinger angibt.

Die Kammfinger sind insbesondere jeweils radial zu dem effektiven Schwenkpunkt des Spiegel-Elements beziehungsweise radial zur Flächennormalen des Spiegel-Elements im unverschwenkten Zustand angeordnet. Die Elektrodenstruktur wird daher auch als radiale Kammstruktur bezeichnet. Die erfindungsgemäßen Vorteile lassen sich grundsätzlich auch mit einer alternativen Anordnung der Kammfinger, beispielsweise einer tangentialen Anordnung der Kammfinger, erreichen.

Die einzelnen Kammelektroden sind jeweils in kreisringabschnittförmigen Bereichen angeordnet. Die Symmetrieeigenschaften der Elektroden ermöglichen eine symmetrische, insbesondere eine achsensymmetrische, Spiegelgeometrie und eine symmetrische, insbesondere eine achsensymmetrische, Ausbildung des Gelenks. Hierdurch ist es möglich, ein gleiches oder zumindest ähnliches Modenspektrum in den beiden Kipprichtungen zu erhalten. Es ist insbesondere möglich, das Spiegel-Element derart auszubilden, dass die Trägheitsmomente und die Federsteifigkeiten symmetrisch in Bezug auf die beiden Kipprichtungen sind. Die Eigenmoden können dann dieselben Symmetrieeigenschaften aufweisen. Die Symmetrieeigenschaften der Elektroden ermöglichen somit eine mechanisch besonders vorteilhafte Ausbildung des Spiegel-Elements, insbesondere im Hinblick auf das Spektrum der Eigenmoden.

Gemäß einem weiteren Aspekt der Erfindung sind sämtliche aktiven Aktuator-Elektroden, insbesondere sämtliche aktiven Komponenten der Aktuator-Einrichtung, ortsfest auf einer Tragestruktur angeordnet. Bei der Tragestruktur kann es sich insbesondere um eine Grundplatte handeln.

Die aktiven Komponenten können zusätzlich zu den aktiven Aktuator-Elektroden auch Sensor-Elektroden zur Erfassung der Verschwenkposition des Spiegel-Elements umfassen. Derartige Sensor-Elektroden können allgemein einen Bestandteil der Verlagerungs-Einrichtung bilden.

Gemäß einem weiteren Aspekt der Erfindung umfasst die Elektrodenstruktur der Verlagerungs-Einrichtung Sensor-Elektroden. Die Sensor-Elektroden sind insbesondere in derselben Ebene angeordnet wie die aktiven Aktuator-Elektroden. Sie sind insbesondere ortsfest auf der Tragestruktur angeordnet.

Die Sensor-Elektroden sind vorzugsweise im Wesentlichen identisch zu den Aktuator-Elektroden ausgebildet. Sie sind vorzugsweise im Wesentlichen identisch zu den Aktuator-Elektroden auf der Tragestruktur angeordnet.

Die Sensor-Elektroden sind insbesondere als Kamm-Elektroden ausgebildet. Die Kämme können insbesondere radial angeordnet sein.

Die Sensor-Elektroden können als Teil der Verlagerungs-Einrichtung in die Elektrodenstruktur mit den Aktuator-Elektroden integriert sein.

Gemäß einem Aspekt der Erfindung ist vorgesehen, zumindest eine Teilmenge der Aktuator-Elektroden gleichzeitig als Sensor-Elektroden zu nutzen. Es ist auch möglich, sämtliche der aktiven Aktuator-Elektroden als Sensor-Elektroden zu nutzen. Hierzu kann vorgesehen sein, die kippwinkelabhängige Aktuatorkapazität bei einer Frequenz, welche deutlich höher, insbesondere mindestens eine Dekade höher liegt als die Aktuierungsfrequenz auszulesen.

Die Sensor-Elektroden sind insbesondere mittels derselben Prozessschritte herstellbar wie die Aktuator-Elektroden. Es ist insbesondere möglich, die Sensor-Elektroden und die Aktuator-Elektroden in einem einzigen Verfahrensschritt herzustellen. Hierdurch wird die Herstellung der Verlagerungs-Einrichtung vereinfacht.

Durch eine ortsfeste Anordnung der aktiven Aktuator-Elektroden, insbesondere sämtliche aktiven Komponenten, kann vermieden werden, dass die Aktuator-Einrichtung bewegte Leitungen, insbesondere bewegte Signal- und/oder Stromleitungen aufweist. Hierdurch werden die mechanischen Eigenschaften der Aktuator-Einrichtung weiter verbessert. Außerdem wird die Zuverlässigkeit der Aktuator-Einrichtung verbessert. Schließlich wird hierdurch auch die Herstellung der Aktuator-Einrichtung, insbesondere des optischen Bauelements mit einer derartigen Aktuator-Einrichtung vereinfacht.

Gemäß einem weiteren Aspekt der Erfindung sind die Komponenten der Aktuator-Einrichtung auf ein Herstellungsverfahren, welches ausschließlich MEMS-Verfahrensschritte verwendet, ausgelegt. Die einzelnen Bestandteile der Aktuator-Einrichtung, insbesondere die Kammfinger der Aktuator-Elektroden, weisen insbesondere ausschließlich horizontale Schichten und vertikale Strukturen auf. Die Aktuatoren sind insbesondere vollständig mittels MEMS-Verfahrensschritten herstellbar. Dies erleichtert den Herstellungsprozess.

Eine weitere Aufgabe der Erfindung besteht darin, ein optisches Bauelement mit mindestens einem Mikrospiegel mit zwei Schwenk-Freiheitsgraden zu verbessern.

Diese Aufgabe wird durch ein optisches Bauelement mit einem derartigen Mikrospiegel und einer Aktuator-Einrichtung gemäß der vorhergehenden Beschreibung gelöst. Die Vorteile ergeben sich aus denen der Aktuator-Einrichtung.

Gemäß einem Aspekt der Erfindung ist der mindestens eine Mikrospiegel mittels eines Gelenks mit mindestens zwei Kipp-Freiheitsgraden gelagert. Bei dem Gelenk handelt es sich insbesondere um ein Festkörper-Gelenk, insbesondere ein Biege-Gelenk. Es kann sich insbesondere um ein Kardangelenk handeln. Bezüglich weiterer Details des Gelenks sei auf die vorherige Beschreibung verwiesen.

Gemäß einem Aspekt der Erfindung weist der Mikrospiegel einen Schwerpunkt auf, dessen Position gerade mit der eines durch das Gelenk definierten effektiven Drehpunkts zusammenfällt.

Hierdurch werden die mechanischen Eigenschaften des optischen Bauelements verbessert. Hierdurch können insbesondere parasitäre Verlagerungen des Mikrospiegels reduziert, insbesondere verhindert, werden. Unter dem Mikrospiegel sei hierbei die Gesamtheit der verlagerbar gelagerten Bestandteile desselben verstanden, insbesondere der Spiegelkörper sowie die direkt mechanisch mit diesem verbundenen weiteren Bestandteile des optischen Bauelements. Die weiteren Bestandteile können insbesondere ein Gegengewicht umfassen, welches gerade geeignet ausgebildet und/oder angeordnet ist, um die Lage des Schwerpunkts zu justieren. Bei dem Schwerpunkt handelt es sich um den mechanischen Schwerpunkt des Mikrospiegels. Durch eine Justierung des Schwerpunkts des verlagerbaren mechanischen Systems derart, dass er mit dem effektiven Drehpunkt dieses Systems zusammenfällt, kann die Stabilität der Positionierung des Mikrospiegels verbessert werden. Es kann insbesondere erreicht werden, dass laterale Beschleunigungen, welche beispielsweise durch mechanische Vibrationen verursacht werden können, nicht aufgrund eines gegenüber dem effektiven Drehpunkt versetzten Massenschwerpunkts in auf den Spiegel wirkende Drehmomente umgesetzt werden.

Bei dem durch das Gelenk definierten effektiven Drehpunkt handelt es sich um den Schnittpunkt der beiden durch das Gelenk definierten Schwenkachsen.

Eine weitere Aufgabe der Erfindung besteht darin, ein Spiegel-Array zu verbessern.

Diese Aufgabe wird durch ein Spiegel-Array mit einer Mehrzahl optischer Bauelemente gemäß der vorhergehenden Beschreibung gelöst. Die Vorteile ergeben sich aus denen der optischen Bauelemente.

Weitere Aufgaben der Erfindung bestehen darin, eine Beleuchtungsoptik für eine Projektionsbelichtungsanlage, ein Beleuchtungssystem für eine Projektionsbelichtungsanlage und eine Projektionsbelichtungsanlage zu verbessern.

Diese Aufgaben werden durch eine Beleuchtungsoptik, ein Beleuchtungssystem bzw. eine Projektionsbelichtungsanlage mit mindestens einem Spiegel-Array gemäß der vorhergehenden Beschreibung gelöst. Die Vorteile ergeben sich aus denen des Spiegel-Arrays.

Die Vorteile kommen insbesondere zum Tragen, sofern es sich bei der Strahlungsquelle um eine EUV-Strahlungsquelle, das heißt um eine Strahlungsquelle, welche Beleuchtungsstrahlung im EUV-Wellenlängenbereich zwischen 5 nm und 30 nm emittiert, handelt.

Weiter wird ein Verfahren zur Herstellung eines mikro- oder nanostrukturierten Bauelements sowie ein entsprechend hergestelltes Bauelement beschrieben.

Weitere Vorteile, Details und Einzelheiten der Erfindung ergeben sich aus der Beschreibung von Ausführungsbeispielen anhand der Zeichnungen. Es zeigen:
- Fig. 1: eine schematische Darstellung einer Projektionsbelichtungsanlage und ihrer Bestandteile,
- Fig. 2: eine schematische Darstellung eines optischen Bauelements mit einer Aktuator- und einer Sensoreinrichtung,
- Fig. 3: eine alternative Darstellung des optischen Bauelements gemäß Fig. 2 bei welcher der Spiegelkörper mit den daran angeordneten Gegenelektroden bzw. Abschirm-Elementen zur Seite geklappt ist,
- Fig. 4: schematisch eine Aufsicht auf den Ausschnitt III in Fig. 3 mit einer schematischen Darstellung der elektrischen Verschaltung eines Teils der Sensor-Einrichtung,
- Fig. 5: eine Ansicht gemäß Fig. 4, bei welcher die mit dem Spiegelkörper verbundenen Kammfinger nicht dargestellt sind,
- Fig. 6 bis 8: schematische Darstellungen eines Ausschnitts aus der Sensor-Einrichtung zur Erläuterung der Sensitivität (Fig. 6) bzw. Insensitivität (Fig. 7 und 8) derselben,
- Fig. 9: eine Ansicht einer Variante eines Gelenks zur Lagerung eines Einzelspiegels, das mit Torsionsfedern realisiert ist,
- Fig. 10: eine Ansicht einer Variante eines Gelenks zur Lagerung eines Einzelspiegels, das mit Torsionsfedern realisiert ist,
- Fig. 11: eine schematische Schnittdarstellung des optischen Bauelements gemäß Fig. 2 zur Verdeutlichung weiterer Aspekte der Aktuator- und Sensor-Einrichtung,
- Fig. 12: eine schematische Darstellung einer weiteren Variante des optischen Bauelements mit einem Gegengewicht um den Schwerpunkt des bewegten Spiegels in den Drehpunkt des Gelenks zu legen.

Zunächst wird der allgemeine Aufbau einer Projektionsbelichtungsanlage 1 und deren Bestandteile beschrieben. Für Details diesbezüglich sei auf die WO 2010/049076 A2 verwiesen, die hiermit vollständig als Bestandteil der vorliegenden Anmeldung in diese integriert ist. Die Beschreibung des allgemeinen Aufbaus der Projektionsbelichtungsanlage 1 ist ausschließlich exemplarisch zu verstehen. Sie dient der Erläuterung einer möglichen Anwendung des Gegenstands der vorliegenden Erfindung. Der Gegenstand der vorliegenden Erfindung kann auch in anderen optischen Systemen, insbesondere in alternativen Varianten von Projektionsbelichtungsanlagen eingesetzt werden.

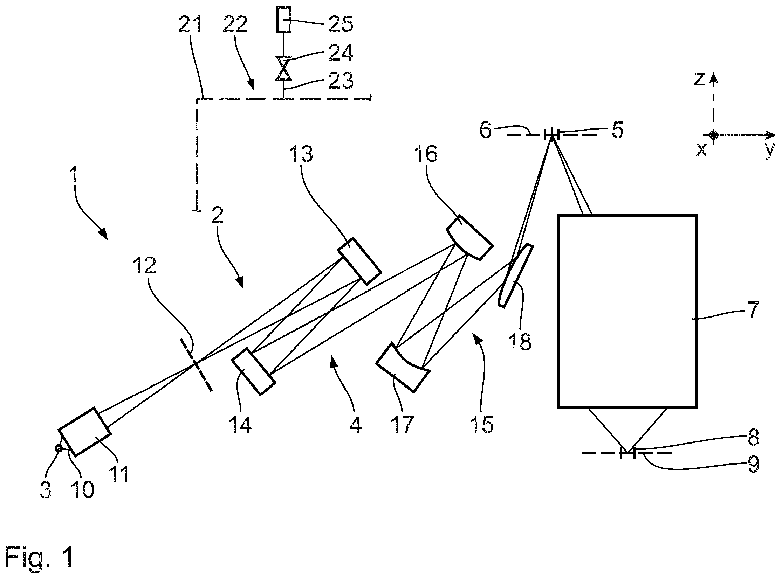

Fig. 1 zeigt schematisch in einem Meridionalschnitt eine Projektionsbelichtungsanlage 1 für die Mikrolithografie. Ein Beleuchtungssystem 2 der Projektionsbelichtungsanlage 1 hat neben einer Strahlungsquelle 3 eine Beleuchtungsoptik 4 zur Belichtung eines Objektfeldes 5 in einer Objektebene 6. Das Objektfeld 5 kann rechteckig oder bogenförmig mit einem x/y-Aspektverhältnis von beispielsweise 13/1 gestaltet sein. Belichtet wird hierbei ein im Objektfeld 5 angeordnetes und in der Fig. 1 nicht dargestelltes reflektierendes Retikel, das eine mit der Projektionsbelichtungsanlage 1 zur Herstellung mikro- bzw. nanostrukturierter Halbleiter-Bauelemente zu projizierende Struktur trägt. Eine Projektionsoptik 7 dient zur Abbildung des Objektfeldes 5 in ein Bildfeld 8 in einer Bildebene 9. Abgebildet wird die Struktur auf dem Retikel auf eine lichtempfindliche Schicht eines im Bereich des Bildfeldes 8 in der Bildebene 9 angeordneten Wafers, der in der Zeichnung nicht dargestellt ist.

Das Retikel, das von einem nicht dargestellten Retikelhalter gehalten ist, und der Wafer, der von einem nicht dargestellten Waferhalter gehalten ist, werden beim Betrieb der Projektionsbelichtungsanlage 1 synchron in der y-Richtung gescannt. Abhängig vom Abbildungsmaßstab der Projektionsoptik 7 kann auch ein gegenläufiges Scannen des Retikels relativ zum Wafer stattfinden.

Bei der Strahlungsquelle 3 handelt es sich um eine EUV-Strahlungsquelle mit einer emittierten Nutzstrahlung im Bereich zwischen 5 nm und 30 nm. Es kann sich dabei um eine Plasmaquelle, beispielsweise um eine GDPP-Quelle (Plasmaerzeugung durch Gasentladung, Gas Discharge Produced Plasma), oder um eine LPP-Quelle (Plasmaerzeugung durch Laser, Laser Produced Plasma) handeln. Auch andere EUV-Strahlungsquellen, beispielsweise solche, die auf einem Synchrotron oder auf einem Free Electron Laser (Freie Elektronenlaser, FEL) basieren, sind möglich.

EUV-Strahlung 10, die von der Strahlungsquelle 3 ausgeht, wird von einem Kollektor 11 gebündelt. Ein entsprechender Kollektor ist beispielsweise aus der EP 1 225 481 A2 bekannt. Nach dem Kollektor 11 propagiert die EUV-Strahlung 10 durch eine Zwischenfokusebene 12, bevor sie auf einen Feldfacettenspiegel 13 trifft. Der Feldfacettenspiegel 13 ist in einer Ebene der Beleuchtungsoptik 4 angeordnet, die zur Objektebene 6 optisch konjugiert ist. Der Feldfacettenspiegel 13 kann beabstandet zu einer zur Objektebene 6 konjugierten Ebene angeordnet sein. Er wird in diesem Fall allgemein als erster Facettenspiegel bezeichnet.

Die EUV-Strahlung 10 wird nachfolgend auch als Nutzstrahlung, Beleuchtungsstrahlung oder als Abbildungslicht bezeichnet.

Nach dem Feldfacettenspiegel 13 wird die EUV-Strahlung 10 von einem Pupillenfacettenspiegel 14 reflektiert. Der Pupillenfacettenspiegel 14 liegt entweder in der Eintrittspupillenebene der Projektionsoptik 7 oder in einer hierzu optisch konjugierten Ebene. Er kann auch beabstandet zu einer derartigen Ebene angeordnet sein.

Der Feldfacettenspiegel 13 und der Pupillenfacettenspiegel 14 sind aus einer Vielzahl von Einzelspiegeln aufgebaut, die nachfolgend noch näher beschrieben werden. Dabei kann die Unterteilung des Feldfacettenspiegels 13 in Einzelspiegel derart sein, dass jede der Feldfacetten, die für sich das gesamte Objektfeld 5 ausleuchten, durch genau einen der Einzelspiegel repräsentiert wird. Alternativ ist es möglich, zumindest einige oder alle der Feldfacetten durch eine Mehrzahl derartiger Einzelspiegel aufzubauen. Entsprechendes gilt für die Ausgestaltung der den Feldfacetten jeweils zugeordneten Pupillenfacetten des Pupillenfacettenspiegels 14, die jeweils durch einen einzigen Einzelspiegel oder durch eine Mehrzahl derartiger Einzelspiegel gebildet sein können.

Die EUV-Strahlung 10 trifft auf die beiden Facettenspiegel 13, 14 unter einem definierten Einfallswinkel auf. Die beiden Facettenspiegel werden insbesondere im Bereich eines normal incidence-Betriebs, d. h. mit einem Einfallswinkel, der kleiner oder gleich 25° zur Spiegelnormalen ist, mit der EUV-Strahlung 10 beaufschlagt. Auch eine Beaufschlagung unter streifendem Einfall (grazing incidence) ist möglich. Der Pupillenfacettenspiegel 14 ist in einer Ebene der Beleuchtungsoptik 4 angeordnet, die eine Pupillenebene der Projektionsoptik 7 darstellt bzw. zu einer Pupillenebene der Projektionsoptik 7 optisch konjugiert ist. Mithilfe des Pupillenfacettenspiegels 14 und einer abbildenden optischen Baugruppe in Form einer Übertragungsoptik 15 mit in der Reihenfolge des Strahlengangs für die EUV-Strahlung 10 bezeichneten Spiegeln 16, 17 und 18 werden die Feldfacetten des Feldfacettenspiegels 13 einander überlagernd in das Objektfeld 5 abgebildet. Der letzte Spiegel 18 der Übertragungsoptik 15 ist ein Spiegel für streifenden Einfall ("Grazing incidence Spiegel"). Die Übertragungsoptik 15 wird zusammen mit dem Pupillenfacettenspiegel 14 auch als Folgeoptik zur Überführung der EUV-Strahlung 10 vom Feldfacettenspiegel 13 hin zum Objektfeld 5 bezeichnet. Das Beleuchtungslicht 10 wird von der Strahlungsquelle 3 hin zum Objektfeld 5 über eine Mehrzahl von Ausleuchtungskanälen geführt. Jedem dieser Ausleuchtungskanäle ist eine Feldfacette des Feldfacettenspiegels 13 und eine dieser nachgeordnete Pupillenfacette des Pupillenfacettenspiegels 14 zugeordnet. Die Einzelspiegel des Feldfacettenspiegels 13 und des Pupillenfacettenspiegels 14 können aktuatorisch verkippbar sein, sodass ein Wechsel der Zuordnung der Pupillenfacetten zu den Feldfacetten und entsprechend eine geänderte Konfiguration der Ausleuchtungskanäle erreicht werden kann. Es resultieren unterschiedliche Beleuchtungssettings, die sich in der Verteilung der Beleuchtungswinkel des Beleuchtungslichts 10 über das Objektfeld 5 unterscheiden.

Zur Erleichterung der Erläuterung von Lagebeziehungen wird nachfolgend unter anderem ein globales kartesisches xyz-Koordinatensystem verwendet. Die x-Achse verläuft in der Fig. 1 senkrecht zur Zeichenebene auf den Betrachter zu. Die y-Achse verläuft in der Fig. 1 nach rechts. Die z-Achse verläuft in der Fig. 1 nach oben.

Unterschiedliche Beleuchtungssettings können über eine Verkippung der Einzelspiegel des Feldfacettenspiegels 13 und einen entsprechenden Wechsel der Zuordnung dieser Einzelspiegel des Feldfacettenspiegels 13 zu den Einzelspiegeln des Pupillenfacettenspiegels 14 erreicht werden. Abhängig von der Verkippung der Einzelspiegel des Feldfacettenspiegels 13 werden die diesen Einzelspiegeln neu zugeordneten Einzelspiegel des Pupillenfacettenspiegels 14 so durch Verkippung nachgeführt, dass wiederum eine Abbildung der Feldfacetten des Feldfacettenspiegels 13 in das Objektfeld 5 gewährleistet ist.

Im Folgenden werden weitere Aspekte der Beleuchtungsoptik 4 beschrieben.

Der eine Feldfacettenspiegel 13 in Form eines Multi- bzw. Mikrospiegel-Arrays (MMA) bildet ein Beispiel für eine optische Baugruppe zur Führung der Nutzstrahlung 10, also des EUV-Strahlungsbündels. Der Feldfacettenspiegel 13 ist als mikroelektromechanisches System (MEMS) ausgebildet. Er weist eine Vielzahl von matrixartig zeilen- und spaltenweise in einem Spiegel-Array 19 angeordneten Einzelspiegeln 20 auf. Die Spiegel-Arrays 19 sind modular ausgeführt. Sie können auf einer als Grundplatte ausgebildeten Tragestruktur angeordnet werden. Hierbei können im Wesentlichen beliebig viele der Spiegel-Arrays 19 nebeneinander angeordnet sein. Die Gesamt-Reflexionsfläche, welche durch die Gesamtheit sämtlicher Spiegel-Arrays 19, insbesondere deren Einzelspiegel 20, gebildet wird, ist somit beliebig erweiterbar. Die Spiegel-Arrays sind insbesondere derart ausgebildet, dass sie eine im Wesentlichen lückenlose Parkettierung einer Ebene ermöglichen. Das Verhältnis der Summe der Reflexionsflächen 26 der Einzelspiegel 20 zu der Gesamtfläche, welche von Spiegel-Arrays 19 abgedeckt wird, wird auch als Integrations-Dichte bezeichnet. Diese Integrations-Dichte beträgt insbesondere mindestens 0,5, insbesondere mindestens 0,6, insbesondere mindestens 0,7, insbesondere mindestens 0,8, insbesondere mindestens 0,9.

Die Spiegel-Arrays 19 werden mittels Fixier-Elementen 29 auf der Grundplatte fixiert. Für Details sei beispielsweise auf die WO 2012/130768 A2 verwiesen.

Die Einzelspiegel 20 sind aktuatorisch verkippbar ausgelegt, wie nachfolgend noch erläutert wird. Insgesamt weist der Feldfacettenspiegel 13 etwa 100000 der Einzelspiegel 20 auf. Je nach Größe der Einzelspiegel 20 kann der Feldfacettenspiegel 13 auch eine andere Anzahl an Einzelspiegeln 20 aufweisen. Die Anzahl der Einzelspiegel 20 des Feldfacettenspiegels 13 beträgt insbesondere mindestens 1000, insbesondere mindestens 5000, insbesondere mindestens 10000. Sie kann bis zu 100000, insbesondere bis zu 300000, insbesondere bis zu 500000, insbesondere bis zu 1000000 betragen.

Vor dem Feldfacettenspiegel 13 kann ein Spektralfilter angeordnet sein, der die Nutzstrahlung 10 von anderen, nicht für die Projektionsbelichtung nutzbaren Wellenlängenkomponenten der Emission der Strahlungsquelle 3 trennt. Der Spektralfilter ist nicht dargestellt.

Der Feldfacettenspiegel 13 wird mit Nutzstrahlung 10 mit einer Leistung von beispielsweise 840 W und einer Leistungsdichte von 6,5 kW/m² beaufschlagt.

Das gesamte Einzelspiegel-Array des Facettenspiegels 13 hat beispielsweise einen Durchmesser von 500 mm und ist dicht gepackt mit den Einzelspiegeln 20 ausgelegt. Die Einzelspiegel 20 repräsentieren, soweit eine Feldfacette durch jeweils genau einen Einzelspiegel realisiert ist, bis auf einen Skalierungsfaktor die Form des Objektfeldes 5. Der Facettenspiegel 13 kann aus 500 jeweils eine Feldfacette repräsentierenden Einzelspiegeln 20 mit einer Dimension von etwa 5 mm in der y-Richtung und 100 mm in der x-Richtung gebildet sein. Alternativ zur Realisierung jeder Feldfacette durch genau einen Einzelspiegel 20 kann jede der Feldfacetten durch Gruppen von kleineren Einzelspiegeln 20 approximiert werden. Eine Feldfacette mit Dimensionen von 5 mm in der y-Richtung und von 100 mm in der x-Richtung kann z. B. mittels eines 1 x 20-Arrays von Einzelspiegeln 20 der Dimension 5 mm x 5 mm bis hin zu einem 10 x 200-Array von Einzelspiegeln 20 mit den Dimensionen 0,5 mm x 0,5 mm aufgebaut sein.

Zum Umstellen der Beleuchtungssettings werden die Kippwinkel der Einzelspiegel 20 verstellt. Die Kippwinkel weisen insbesondere einen Verlagerungsbereich von ± 50 mrad, insbesondere ± 100 mrad auf. Bei der Einstellung der Kippposition der Einzelspiegel 20 wird eine Genauigkeit von besser als 0,2 mrad, insbesondere besser als 0,1 mrad erreicht.

Die Einzelspiegel 20 des Feldfacettenspiegels 13 und des Pupillenfacettenspiegels 14 bei der Ausführung der Beleuchtungsoptik 4 nach Fig. 1 tragen Multilayer-Beschichtungen zur Optimierung ihrer Reflektivität bei der Wellenlänge der Nutzstrahlung 10. Die Temperatur der Multilayer-Beschichtungen sollte 425 K beim Betreiben der Projektionsbelichtungs-anlage 1 nicht überschreiten. Dies wird durch einen geeigneten Aufbau der Einzelspiegel 20 erreicht. Für Details wird auf DE 10 2013 206 529 A1 verwiesen, die hiermit vollständig in die vorliegende Anmeldung integriert ist.

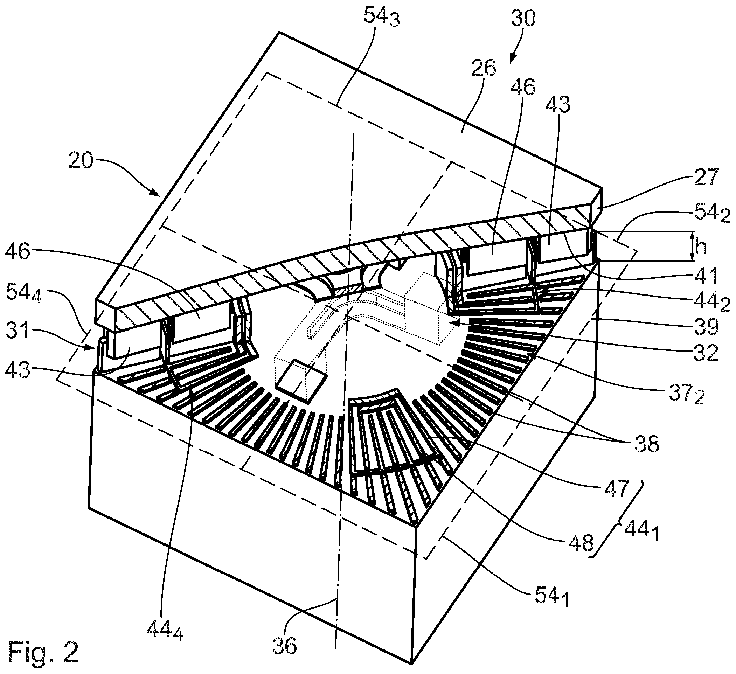

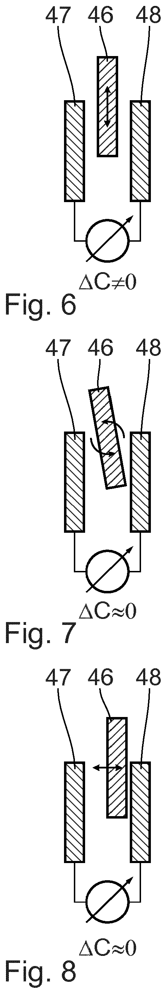

Die Einzelspiegel 20 der Beleuchtungsoptik 4 sind in einer evakuierbaren Kammer 21 untergebracht, von der in den Fig. 2 und 6 eine Begrenzungswand 22 angedeutet ist. Die Kammer 21 kommuniziert über eine Fluidleitung 23, in der ein Absperrventil 24 untergebracht ist, mit einer Vakuumpumpe 25. Der Betriebsdruck in der evakuierbaren Kammer 21 beträgt einige Pascal, insbesondere 3 Pa bis 5 Pa (Partialdruck H₂). Alle anderen Partialdrücke liegen deutlich unterhalb von 1 x 10⁻⁷ mbar.

Der die Mehrzahl von Einzelspiegeln 20 aufweisende Spiegel bildet zusammen mit der evakuierbaren Kammer 21 eine optische Baugruppe zur Führung eines Bündels der EUV-Strahlung 10.

Jeder der Einzelspiegel 20 kann eine Reflexionsfläche 26 mit Abmessungen von 0,1 mm x 0,1 mm, 0,5 mm x 0,5 mm, 0,6 mm x 0,6 mm oder auch von bis zu 5 mm x 5 mm und größer aufweisen. Die Reflexionsfläche 26 kann auch kleinere Abmessungen aufweisen. Sie weist insbesondere Seitenlängen im µm- oder unteren mm-Bereich auf. Die Einzelspiegel 20 werden daher auch als Mikrospiegel bezeichnet. Die Reflexionsfläche 26 ist Teil eines Spiegelkörpers 27 des Einzelspiegels 20. Der Spiegelkörper 27 trägt die Mehrlagen-(Multilayer)-Beschichtung.

Mit Hilfe der Projektionsbelichtungsanlage 1 wird wenigstens ein Teil des Retikels auf einen Bereich einer lichtempfindlichen Schicht auf dem Wafer zur lithografischen Herstellung eines mikro- bzw. nanostrukturierten Bauelements, insbesondere eines Halbleiterbauelements, z.B. eines Mikrochips abgebildet. Je nach Ausführung der Projektionsbelichtungsanlage 1 als Scanner oder als Stepper werden das Retikel und der Wafer zeitlich synchronisiert in der y-Richtung kontinuierlich im Scannerbetrieb oder schrittweise im Stepperbetrieb verfahren.

Im Folgenden werden weitere Details und Aspekte der Spiegel-Arrays 19, insbesondere der optischen Bauelemente, welche die Einzelspiegel 20 umfassen, beschrieben.

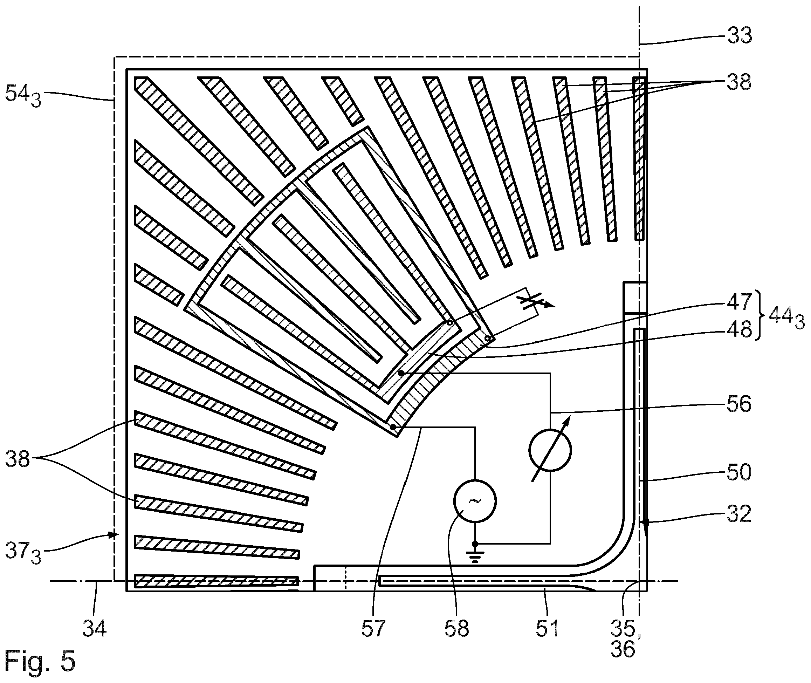

Zunächst wird unter Bezugnahme auf die Fig. 2 bis 5 eine erste Variante eines optischen Bauelements 30 mit einem Einzelspiegel 20 sowie insbesondere der Verlagerungs-Einrichtung 31 zur Verlagerung, insbesondere zur Verschwenkung des Einzelspiegels 20, beschrieben.

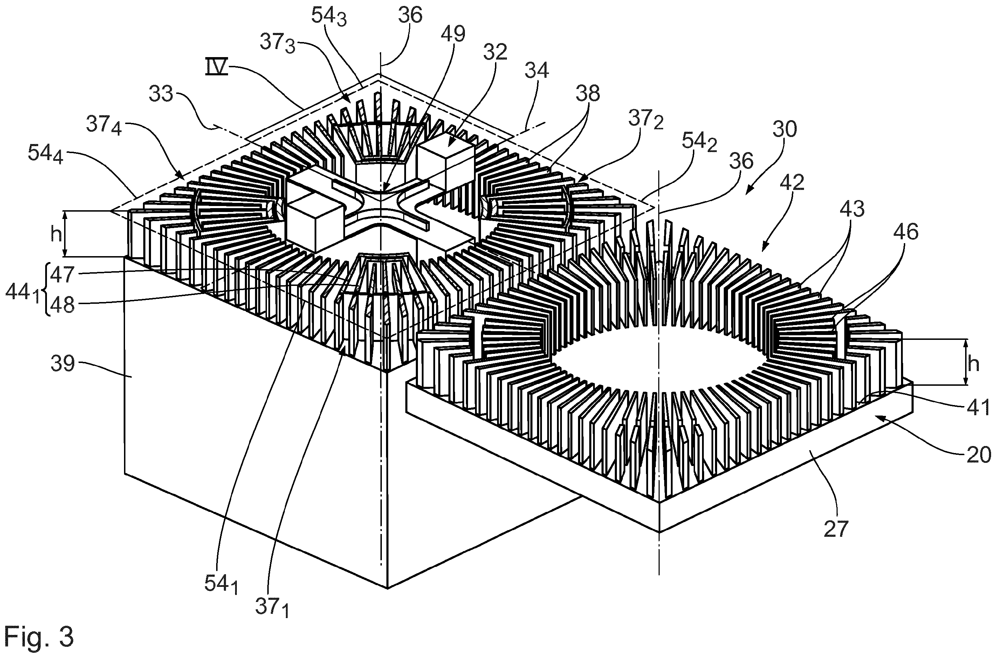

Die Darstellung gemäß Fig. 3 entspricht der gemäß Fig. 2, wobei in der Fig. 3 der Spiegelkörper 27 des Einzelspiegels 20 zur Seite weggeklappt ist. Hierdurch werden die Strukturen der Verlagerungs-Einrichtung 31 sowie der Sensor-Einrichtung besser sichtbar.

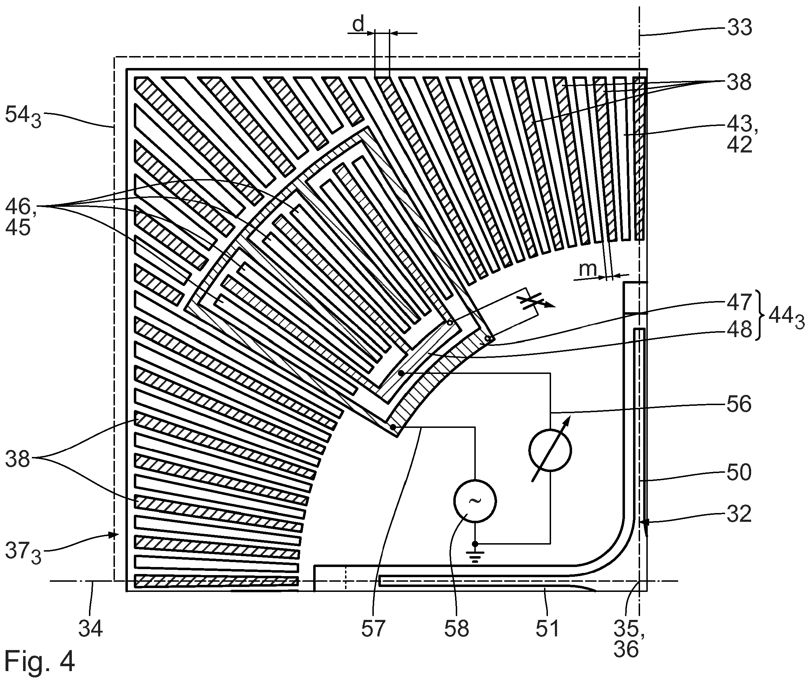

Fig. 4 zeigt eine Schnittdarstellung eines Schnitts parallel zur Aktuator-Ebene 40 des Ausschnitts IV des optischen Bauelements 30 gemäß Fig. 3.

Das optische Bauelement umfasst den Einzelspiegel 20, welcher insbesondere als Mikrospiegel ausgebildet ist. Der Einzelspiegel 20 umfasst den vorgehend beschriebenen Spiegelkörper 27, auf dessen Vorderseite die Reflexionsfläche 26 ausgebildet ist. Die Reflexionsfläche 26 ist insbesondere durch eine Viellagenstruktur gebildet. Sie ist insbesondere strahlungsreflektierend für die Beleuchtungsstrahlung 10, insbesondere für EUV-Strahlung.

Gemäß der in den Figuren dargestellten Variante ist die Reflexionsfläche 26 quadratisch ausgebildet, jedoch teilweise angeschnitten dargestellt, um auch die Aktuatorik zu zeigen. Sie ist allgemein rechteckig ausgebildet. Sie kann auch dreieckig oder sechseckig ausgebildet sein. Sie ist insbesondere derart kachelartig ausgebildet, dass eine lückenlose Parkettierung einer Ebene mit den Einzelspiegeln 20 möglich ist. Der Einzelspiegel 20 ist mittels eines nachfolgend noch näher beschriebenen Gelenks 32 gelagert. Er ist insbesondere derart gelagert, dass er zwei KippFreiheitsgrade aufweist. Das Gelenk 32 ermöglicht insbesondere die Verkippung des Einzelspiegels 20 um zwei Kippachsen 33, 34. Die Kippachsen 33, 34 stehen senkrecht aufeinander. Sie schneiden sich in einem zentralen Schnittpunkt, welcher als effektiver Schwenkpunkt 35 bezeichnet wird.

Sofern sich der Einzelspiegel 20 in einer unverschwenkten Neutralposition befindet, so liegt der effektive Schwenkpunkt 35 auf einer Flächenormalen 36, welchen durch einen zentralen Punkt, insbesondere den geometrischen Schwerpunkt der Reflexionsfläche 26 verläuft.

Sofern nichts anderes angegeben ist, wird im Folgenden unter der Richtung der Flächennormalen 36 stets die Richtung derselben in der unverkippten Neutralstellung des Einzelspiegels 20 verstanden.

Im Folgenden wird zunächst die Verlagerungs-Einrichtung 31 näher beschrieben.

Die Verlagerungs-Einrichtung 31 umfasst eine Elektrodenstruktur mit Aktuator-Wandler-Statorelektroden 37ᵢ und Aktuator-Wandler-Spiegelelektroden 42. Gemäß der in den Figuren 2 bis 5 dargestellten Variante umfasst die Elektrodenstruktur vier Aktuator-Wandler-Statorelektroden 37₁, 37₂ ,37₃ und 37₄. Die Anzahl der Aktuator-Wandler-Statorelektroden 37ᵢ beträgt allgemein mindestens 2. Sie kann 3, 4 oder mehr betragen.

Sämtliche Aktuator-Wandlerelektroden 37ᵢ, 42 sind als Kamm-Elektroden mit einer Mehrzahl von Kammfingern 38 ausgebildet. Die jeweils komplementären Kammfinger von Spiegel und Stator greifen hierbei ineinander. Die Kämme der einzelnen Aktuator-Elektroden 37ᵢ umfassen jeweils 30 Aktuator-Wandler Stator Kammfinger 38, welche im Folgenden verkürzt auch als Statorkammfinger oder lediglich als Kammfinger bezeichnet werden. Eine jeweils andere Anzahl ist ebenso möglich. Die Anzahl der Kammfinger 38 der Aktuator-Wandler-Statorelektroden 37ᵢ beträgt insbesondere mindestens 2, insbesondere mindestens 3, insbesondere mindestens 5, insbesondere mindestens 10. Sie kann bis zu 50, insbesondere bis zu 100 betragen. Die Kämme der Aktuator-Wandler-Spiegelelektroden 42 umfassen entsprechend Aktuator-Wandler-Spiegelkammfinger 43, welche im Folgenden verkürzt auch als Spiegelkammfinger oder lediglich als Kammfinger bezeichnet werden. Die Anzahl der Spiegelkammfinger 43 entspricht der Anzahl der Statorkammfinger. Sie kann auch jeweils um eins von der Anzahl der Statorkammfinger abweichen.

Die Kammfinger 38 sind derart angeordnet, dass sie in Bezug auf die Flächennormale 36 bzw. den effektiven Schwenkpunkt 35 in radialer Richtung verlaufen. Gemäß einer in den Figuren nicht dargestellten Variante können die Kammfinger 38, 43 auch tangential zu Kreisen um den effektiven Schwenkpunkt 35 angeordnet sein. Sie können auch eine Ausbildung aufweisen, welche Ausschnitten aus konzentrischen Kreiszylinder-Mantelflächen um die Flächennormale 36 entsprechen.

Sämtliche der Aktuator-Wandler-Statorelektroden 37ᵢ sind auf einer Tragestruktur in Form eines Substrats 39 angeordnet. Sie sind insbesondere ortsfest auf dem Substrat 39 angeordnet. Sie sind insbesondere in einer einzigen, durch die Vorderseite des Substrats 39 definierten Ebene angeordnet. Diese Ebene wird auch als Aktuator-Ebene 40 oder als Kamm-Ebene bezeichnet.

Als Substrat 39 dient insbesondere ein Wafer. Das Substrat 39 wird auch als Grundplatte bezeichnet.

Die Aktuator-Wandler-Statorelektroden 37ᵢ sind jeweils in einem Bereich auf dem Substrat 39 angeordnet, welcher einerseits eine quadratisch äußere Einhüllende, andererseits eine kreisförmige innere Einhüllende aufweist. Alternativ hinzu können die Aktuator-Wandler-Statorelektroden 37ᵢ auch in einem kreisringförmigen Bereich auf dem Substrat 39 angeordnet sein. Hierbei ist auch die äußere Einhüllende kreisförmig ausgebildet. Die einzelnen Aktuator-Wandler-Statorelektroden 37ᵢ sind insbesondere jeweils in kreisringabschnittförmigen Bereichen angeordnet. Die Elektrodenstruktur insgesamt, das heißt sämtliche Aktuator-Wandler-Statorelektroden 37ᵢ sind in einem Bereich angeordnet, welcher eine äußere Einhüllende aufweist, die gerade derjenigen der Reflexionsfläche des Einzelspiegels 20 entspricht. Sie kann auch in einen etwas kleineren, insbesondere etwa 5 % bis 25 % kleineren Bereich angeordnet sein.

Die Elektrodenstruktur weist eine Radiärsymmetrie auf. Sie weist insbesondere eine vierzählige Radiärsymmetrie auf. Die Elektrodenstruktur kann auch eine andere Radiärsymmetrie aufweisen.

Sie kann insbesondere eine dreizählige Radiärsymmetrie aufweisen. Sie weist insbesondere eine k-zählige Radiärsymmetrie auf, wobei k die Anzahl der Aktuator-Wandler-Statorelektroden 37ᵢ angibt. Abgesehen von der Unterteilung der Elektrodenstruktur in die unterschiedlichen Aktuator-Wandler-Statorelektroden 37ᵢ weist die Elektrodenstruktur eine n-zählige Radiärsymmetrie auf, wobei n gerade der Gesamtzahl der Kammfinger 38 sämtlicher Aktuator-Wandler-Statorelektroden 37ᵢ entspricht.

Die einzelnen Aktuator-Wandler-Statorelektroden 37ᵢ sind abgesehen von ihrer unterschiedlichen Anordnung auf dem Substrat 39 identisch ausgebildet. Dies ist nicht zwingend notwendig. Sie können auch unterschiedlich ausgebildet sein. Sie können insbesondere in Abhängigkeit der mechanischen Eigenschaften des Gelenks 32 ausgebildet sein.

Die Kammfinger 38 sind radial zum effektiven Schwenkpunkt 35, bzw. radial zur Ausrichtung der Flächennormalen 36 im unverschwenkten Neutralzustand des Einzelspiegels 20 angeordnet.

Bei Einzelspiegeln 20, deren Spiegelkörper 27 Abmessungen von 1 mm · 1 mm aufweisen, weisen die Kammfinger 38 an ihrem in radialer Richtung äußeren Ende eine Dicke d von höchstens 5 µm auf. Allgemein liegt die maximale Dicke d der Kammfinger 38 an ihrem in Radialrichtung äußeren Ende im Bereich von 1 µm bis 20 µm, insbesondere im Bereich 3 µm bis 10 µm.

Die Kammfinger 38 weisen eine Höhe h, das heißt eine Erstreckung in Richtung der Flächennormalen 36, im Bereich von 10 µm bis 100 µm, insbesondere im Bereich von 20 µm bis 50 µm auf. Andere Werte sind ebenfalls denkbar. Die Höhe h ist in Radialrichtung konstant. Sie kann auch in Radialrichtung abnehmen. Hierdurch können größere Kippwinkel ermöglicht werden, ohne dass dies dazu führt, dass die Kammfinger der Aktuator-Spiegelelektrode 42 auf die Grundplatte auftreffen.

Benachbarte Kammfinger 38, 43 der Aktuatorelektroden 37ᵢ einerseits und der Aktuator-Spiegelelektroden 42 andererseits weisen im unverschwenkten Zustand des Einzelspiegels 20 einen Mindestabstand im Bereich von 1 µm bis 10 µm, insbesondere im Bereich von 3 µm bis 7 µm, insbesondere von etwa 5 µm auf. Für Einzelspiegel 20 mit kleineren oder größeren Abmessungen können diese Werte entsprechend skaliert werden.

Bei diesem Mindestabstand m handelt es sich um den minimalen Abstand benachbarter Spiegel- und Statorkammfinger gemessen im neutralen, unverschwenkten Zustand des Einzelspiegels 20. Bei einer Verkippung des Einzelspiegels 20 können sich die Kammfinger aneinander annähern. Der Mindestabstand m ist derart gewählt, dass es auch bei einer maximalen Verkippung des Einzelspiegels 20 nicht zu einer Kollision benachbarter Spiegel- und Statorkammfinger kommt. Hierbei sind auch Fertigungstoleranzen berücksichtigt. Derartige Fertigungstoleranzen liegen bei wenigen Mikrometern, insbesondere bei höchstens 3 µm, insbesondere höchstens 2 µm, insbesondere höchstens 1 µm.

Die maximal mögliche Annäherung benachbarter Kammfinger 38, 43 lässt sich aus den geometrischen Details derselben und deren Anordnung sowie der maximal möglichen Verkippung des Einzelspiegels 20 auf einfache Weise bestimmen. Bei der vorliegenden Ausführungsform beträgt die maximale Annäherung benachbarter Kammfinger 38, 43 bei einer Verkippung des Einzelspiegels 20 um 100 mrad etwa 2 µm. Die maximale Annäherung beträgt insbesondere weniger als 10 µm, insbesondere weniger als 7 µm, insbesondere weniger als 5 µm, insbesondere weniger als 3 µm.

Die Aktuator-Wandler-Statorelektroden 37ᵢ wirken jeweils mit einer Aktuator-Spiegelelektrode 42 zusammen. Die Aktuator-Spiegelelektrode 42 ist mit dem Spiegelkörper 27 verbunden. Die Aktuator-Spiegelelektrode 42 ist insbesondere mechanisch fix mit dem Spiegelkörper 27 verbunden. Die Aktuator-Wandler-Spiegelelektroden 42 bilden eine Gegenelektrode zu den Aktuator-Wandler-Statorelektroden 37ᵢ. Sie werden daher auch einfach als Gegenelektrode bezeichnet.

Die Aktuator-Spiegelelektrode 42 bildet eine passive Elektrodenstruktur. Hierunter sei verstanden, dass die Aktuator-Spiegelelektrode 42 mit einer fixen, konstanten Spannung beaufschlagt wird.

Die Aktuator-Spiegelelektrode 42 ist komplementär zu den Aktuator-Wandler-Statorelektroden 37ᵢ ausgebildet. Sie bildet insbesondere einen Ring mit Aktuator-Wandler Spiegel Kammfingern 43, welche im Folgenden vereinfachend auch als Spiegel-Kammfinger oder lediglich als Kammfinger 43 bezeichnet werden. Die Spiegel-Kammfinger 43 der Aktuator-Spiegelelektrode 42 entsprechen in ihren geometrischen Eigenschaften im Wesentlichen den Stator-Kammfingern 38 der Aktuator-Wandler-Statorelektroden 37ᵢ.

Sämtliche der Kammfinger 38, 43 können dieselbe Höhe h, d. h. identische Abmessungen in Richtung der Flächennormalen 36 aufweisen. Dies erleichtert den Herstellungsprozess.

Die Spiegel-Kammfinger 43 der Aktuator-Spiegelelektrode 42 können in Richtung der Flächennormalen 36 auch eine andere Höhe aufweisen als die Stator-Kammfinger 38 der aktiven Aktuator-Wandler-Statorelektroden 37ᵢ.

Die Kammfinger 38, 43 können eine in Radialrichtung abnehmende Höhe h aufweisen. Es ist auch möglich, die Kammfinger 38, 43 im Bereich der Ecken des optischen Bauelements 30 kürzer auszubilden als die übrigen Kammfinger 38, 43. Hierdurch kann ein größerer Kippwinkel des Einzelspiegels 20 ermöglicht werden.

Die Aktuator-Spiegelelektrode 42 ist insbesondere derart ausgebildet, dass jeweils einer der Kammfinger 43 der Aktuator-Spiegelelektrode 42 in einem Zwischenraum zwischen zwei der Kammfinger 38 der Aktuator-Wandler-Statorelektroden 37ᵢ eintauchen kann.

Die Aktuator-Spiegelelektrode 42 ist elektrisch leitfähig mit dem Spiegelkörper 27 verbunden. Ihre Kammfinger 43 sind daher äquipotential. Der Spiegelkörper 27 ist über eine elektrisch leitfähige Gelenkfeder niederohmig mit der Grundplatte verbunden. Prinzipiell kann man auch das Spiegelsubstrat, das heißt den Spiegelkörper 27, die Aktuator-Spiegelelektroden 42 und Sensor-Spiegelelektroden 45 über getrennte Zuleitungen über das Festkörpergelenk 32 individuell elektrisch anbinden und so beispielsweise auf unterschiedliche Potentiale legen oder bezüglich Störungen und/oder Übersprechen entkoppeln. Die Grundplatte kann auf Erde liegen muss aber nicht. Alternativ kann man der Spiegel über leitfähige Gelenkfeder auf einem anderen mit einer Spannungsquelle verbunden jedoch von der Spiegelplatte galvanische entkoppelt sein. Hierdurch ist es möglich den Spiegel mit einer festen oder variablen Bias Spannung zu beaufschlagen.

Die Aktuator-Wandler-Statorelektroden 37ᵢ sind zur Verschwenkung des Einzelspiegels 20 mit einer Aktuator-Spannung U_{A} beaufschlagbar. Die Aktuator-Wandler-Statorelektroden 37ᵢ werden daher auch als aktive Aktuator-Wandler-Statorelektroden 37ᵢ bezeichnet. Zur Beaufschlagung der Aktuator-Wandler-Statorelektroden 37ᵢ mit der Aktuator-Spannung U_{A} ist eine in den Figuren nicht dargestellte Spannungsquelle vorgesehen. Die Aktuator-Spannung U_{A}, beträgt höchstens 200 Volt, insbesondere höchstens 100 Volt. Durch geeignete Beaufschlagung einer Auswahl der Aktuator-Wandler-Statorelektroden 37ᵢ mit der Aktuator-Spannung U_{A} kann der Einzelspiegel 20 um bis zu 50 mrad, insbesondere bis zu 100 mrad, insbesondere bis 150mrad aus einer Neutralstellung verkippt werden. Alternativ können die Aktuoren auch mit einer Ladungsquelle (Stromquelle) angesteuert werden.

Die unterschiedlichen Aktuator-Wandler-Statorelektroden 37ᵢ können zur Verschwenkung des Einzelspiegels 20 mit unterschiedlichen Aktuator-Spannungen U_{Ai} beaufschlagt werden. Zur Steuerung der Aktuator-Spannungen U_{Ai} ist eine in den Figuren nicht dargestellte SteuerEinrichtung vorgesehen.

Zur Verkippung eines der Einzelspiegel 20 wird an eine der Aktuator-Wandler-Statorelektroden 37ᵢ eine Aktuator-Spannung U_{A} angelegt. Gleichzeitig wird an der bezüglich der Flächennormalen 36 gegenüberliegenden Aktuator-Wandler-Statorelektrode 37ⱼ eine hiervon abweichende Aktuator-Spannung U_{A2} ≠ U_{A1} angelegt. Hierbei kann U_{A2} = 0 Volt sein. Es ist insbesondere möglich, ausschließlich eine der Aktuator-Wandler-Statorelektroden 37ᵢ mit der Aktuator-Spannung U_{A1} zu beaufschlagen, während sämtliche anderen Aktuator-Wandler-Statorelektroden 37ⱼ auf einer Spannung von 0 Volt gehalten werden.

Bei einer Verkippung des Einzelspiegels 20 tauchen die Kammfinger der Aktuator-Spiegelelektrode 42 auf einer Seite, insbesondere im Bereich der mit der Aktuator-Spannung U_{A} beaufschlagten Aktuator-Wandler-Statorelektrode 37ᵢ tiefer zwischen die Kammfinger 38 dieser Aktuator-Wandler-Statorelektrode 37ᵢ ein. Auf der gegenüberliegenden Seite der Kippachse 33 taucht die Aktuator-Spiegelelektrode 42 weniger tief in die Aktuator-Wandler-Statorelektroden 37ⱼ ein. Es kann sogar zu einem zumindest bereichsweisen Austauchen der Aktuator-Spiegelelektrode 42 aus den Aktuator-Wandler-Statorelektroden 37ⱼ kommen.

Der Kammüberlapp, das heißt die Eintauchtiefe der Aktuator-Spiegelelektrode 42 zwischen die Aktuator-Wandler-Statorelektroden 37ᵢ beträgt bei einer Spiegeldimension von etwa 0.5mm x 0.5mm in der Neutralstellung des Einzelspiegels 20 30 µm.

In der Neutralposition eine Verkippung des Spiegels 20 um 100 mrad zu einer maximalen Verringerung des Abstands zwischen den Kammfingern 43 der Aktuator-Spiegelelektrode 42 und den Kammfingern 38 der Aktuator-Wandler-Statorelektroden 37ᵢ um 1,1 µm kommt. Die Kammfinger 43 der Aktuator-Spiegelelektrode 42 und die Kammfinger 38 der Aktuator-Wandler-Statorelektroden 37ᵢ sind somit in jeder Verschwenkposition des Spiegels 20 beabstandet zueinander, insbesondere berührungsfrei. Die Eintauchtiefe, das heißt der Kammüberlapp, ist insbesondere derart gewählt, dass dies sichergestellt ist.

Gemäß einer Alternative sind die Kammfinger 38, 43 im äußeren Bereich etwas kürzer und weisen daher einen geringeren Überlapp, das heißt eine geringere Eintauchtiefe, auf. Die Eintauchtiefe im äußersten Bereich kann beispielsweise etwa halb so groß sein wie die Eintauchtiefe im inneren Bereich. Auch diese Angaben beziehen sich auf die Neutralposition des Spiegels 20.

Durch eine Abhängigkeit der Eintauchtiefe der Kammfinger 38, 43 von deren Radialposition lässt sich auch die Charakteristik, insbesondere die Linearität der Aktuierung, beeinflussen. Da sämtliche der Aktuator-Wandler-Statorelektroden 37ᵢ in einer einzigen Ebene, der Aktuator-Ebene 40, angeordnet sind, kann auf eine komplexe, serielle Kinematik verzichtet werden. Die Verlagerungs-Einrichtung 31 zeichnet sich durch eine Parallelkinematik aus. Die Verlagerungs-Einrichtung 31 weist insbesondere keine beweglich angeordneten aktiven Komponenten auf. Sämtliche der mit der Aktuator-Spannung U_{A} beaufschlagbaren Aktuator-Wandler-Statorelektroden 37ᵢ sind unbeweglich ortsfest auf dem Substrat 39 angeordnet. Zur Erfassung der Verschwenkposition des Einzelspiegels 20 ist eine Sensor-Einrichtung vorgesehen. Die Sensor-Einrichtung kann einen Bestandteil der Verlagerungs-Einrichtung 31 bilden.

Die Sensor-Einrichtung umfasst Sensor-Wandlerspiegelelektroden 45 und Sensor-Wandlerstatorelektroden 44ᵢ.

Die Sensor-Einheit umfasst vier Sensor-Wandlerstatorelektroden 44₁ bis 44₄. Die Sensor-Wandlerstatorelektroden 44ᵢ werden vereinfachend auch lediglich als Sensor-Elektroden bezeichnet. Es ist für die Ansteuerung vorteilhaft, wenn die Anzahl der Sensor-Wandler-statorelektroden 44ᵢ gerade der Anzahl der Aktuator-Wandler-Statorelektroden 37ᵢ entspricht. Die Anzahl der Sensor-Wandlerstatorelektroden 44ᵢ kann jedoch auch von der Anzahl der Aktuator-Wandler-Statorelektroden 37ᵢ abweichen.

Die Sensor-Wandlerstatorelektroden 44₁ bis 44₄ sind bei der Variante gemäß der Figuren 2 bis 5 jeweils entlang der Diagonalen des Substrats 39 angeordnet. Bei der in den Fig. 2 bis 5 dargestellten Variante sind die Sensor-Wandlerstatorelektroden 44₁ bis 44₄ relativ zu den Kippachsen 33, 34 des Gelenks 32 um 45 ° versetzt angeordnet.

Die Aktuator-Wandler-Statorelektroden 37ᵢ sind jeweils in Quadranten 54₁ bis 54₄ auf dem Substrat 39 angeordnet. Die Sensor-Wandlerstatorelektroden 44ᵢ sind jeweils in demselben Quadranten 54₁ bis 54₄ angeordnet wie jeweils eine der Aktuator-Wandler-Statorelektroden 37ᵢ. Die Aktuator-Einrichtung 31, insbesondere die Anordnung und Ausbildung der Aktuator-Wandler-Statorelektroden 37ᵢ hat im Wesentlichen dieselben Symmetrieeigenschaften wie die Reflexionsfläche 26 des Einzelspiegels 20. Die Sensor-Einrichtung, insbesondere die Sensor-Wandlerstatorelektroden44ᵢ, hat im Wesentlichen dieselben Symmetrieeigenschaften wie die Reflexionsfläche 26 des Einzelspiegels 20.

Jeweils zwei einander bezüglich des effektiven Schwenkpunkts 35 gegenüberliegende Sensor-Wandlerstatorelektroden 44ᵢ sind differenziell verschaltet. Eine derartige Verschaltung ist jedoch nicht zwingend notwendig. Allgemein ist es vorteilhaft, wenn jeweils zwei einander bezüglich des effektiven Schwenkpunkts 35 gegenüberliegende Sensor-Elektroden 44ᵢ derart ausgebildet und angeordnet sind, dass sie differenziell auslesbar sind.

Die Sensor-Wandlerstatorelektroden 44ᵢ sind als Kamm-Elektroden ausgebildet. Die Sensor-Wandlerstatorelektroden 44ᵢ können insbesondere entsprechend den Aktuator-Wandlerstatorelektroden 37ᵢ, auf deren Beschreibung hiermit verwiesen wird, ausgebildet sein. Die Sensor-Wandlerstatorelektroden 44ᵢ umfassen jeweils eine Sensor-Wandlerstatorsenderelektrode 47, im Folgenden auch kurz Sender-Elektrode, und eine Sensor-Wandlerstatorempfängerelektrode, im Folgenden auch kurz Empfänger-Elektrode, 48. Sowohl die sensor-Wandlerstatorsenderelektrode 47 als auch die Sensor-Wandlerstatorempfängerelektrode 48 weisen eine Kammstruktur auf. Sie umfassen insbesondere eine Mehrzahl von Kammfingern. Die Kammfinger der Sensor-Wandlerstatorsenderelektrode 47 sind insbesondere alternierend zu den Kammfingern der Sensor-Wandlerstatorempfängerelektrode 48 angeordnet.

Die Sensor-Einrichtung umfasst für jede der Sensor-Wandlerstatorelektroden 44ᵢ eine Sensor-Wandlerspiegelelektrode 45. Gemäß einer vorteilhaften Ausführungsform bilden die Sensor-Wandlerspiegelelektroden 45 jeweils eine Abschirm-Einheit der Sensor-Wandlerstatorelektroden 44ᵢ. Die Sensor-Wandlerspiegelelektrode 45 umfasst jeweils Kammelemente mit einer Mehrzahl von Kammfingern 46. Die Sensor-Wandlerspiegelelektrode 45 ist entsprechend einer Gegenelektrode passend zu den Sensor-Wandlerstatorelektroden 44ᵢ ausgebildet. Die Sensor-Wandlerspiegelelektroden 45 können insbesondere entsprechend den Aktuator-Wandler-spiegelelektroden 42, auf deren Beschreibung hiermit verwiesen wird, ausgebildet sein.

Die Sensor-Wandlerspiegelelektroden 45 sind jeweils fix mit dem Spiegelkörper 27 verbunden. Sie sind im Bereich der Diagonalen des Spiegelkörpers 27 angeordnet. Bei einer Verkippung des Einzelspiegels 20 kann die Sensor-Wandlerspiegelelektrode 45 jeweils unterschiedlich tief zwischen die Kammfinger der Sensor-Wandlerstatorelektroden 44ᵢ, insbesondere zwischen die Sender-Elektrode 47 und die Empfänger-Elektrode 48 eintauchen. Hierdurch kommt es zu einer variablen Abschirmung benachbarter Kammfinger, insbesondere zu einer variablen Abschirmung der Empfänger-Elektrode 48 von der Sender-Elektrode 47. Dies führt dazu, dass sich die Kapazität zwischen den benachbarten Kammfingern der Sensor-Wandlerstatorelektroden 44ᵢ bei einer Verschwenkung des Einzelspiegels 20 ändert. Die Kapazitätsänderung kann gemessen werden. Hierzu sind die Eingänge eines Messgeräts, wie schematisch in Fig. 4 dargestellt ist, alternierend mit den Kammfingern der Sensor-Wandlerstatorelektroden 44ᵢ verbunden.

Die Eintauchtiefe der Sensor-Wandlerspiegelelektroden 45 zwischen die Sensor-Wandlerstatorelektroden 44ᵢ, insbesondere zwischen die Sender-Elektroden 47 und die Empfänger-Elektroden 48 beträgt 30 µm. Hierdurch wird sichergestellt, dass die Kammfinger 46 auch in der maximal verkippten Verschwenkposition überall noch eine Resteintauchtiefe zwischen die Sender-Elektroden 47 und die Empfänger-Elektroden 48 aufweisen, das heißt nie vollständig austauchen. Hierdurch wird der differenzielle Sensorbetrieb über den vollständigen Verkippungsbereich gewährleistet. Andererseits ist die Eintauchtiefe der Sensor-Wandlerspiegelelektrode 45 derart gewählt, dass es auch in der maximal verkippten Verschwenkposition des Einzelspiegels 20 nicht zu einer Kollision derselben mit dem Substrat 39 kommt.

Zur Messung der Kapazität zwischen der Sender-Elektrode 47 und der Empfänger-Elektrode 48 der Sensor-Wandlerstatorelektroden 44ᵢ wird an die Sender-Elektrode 47 eine elektrische Spannung, insbesondere eine Sensor-Spannung U_{S} angelegt. Als Sensor-Spannung U_{S} dient insbesondere eine Wechselspannung.

Die Sensor-Einrichtung ist sensitiv im Hinblick auf die Eintauchtiefe der Kammfinger 46 zwischen benachbarten Kammfingern der Sensor-Wandlerstatorelektroden 44ᵢ (Fig. 6).

Die Sensor-Einrichtung ist insensitiv gegenüber einer reinen Verschwenkung des Kammfingers 46 relativ zu der Sender-Elektrode 47 und der Empfänger-Elektrode 48 (Fig. 7).

Die Sensor-Einrichtung ist insensitiv gegenüber einer lateralen Verschiebung des Abschirm-Elements, welche den Abstand desselben zur Sender-Elektrode 47 und zur Empfänger-Elektrode 48 ändert, die Eintauchtiefe des Kammfingers 46 zwischen den benachbarten Sender- und Empfänger-Elektroden 47, 48 jedoch unverändert lässt (Fig. 8).

Im Folgenden werden weitere Details die Sensoreinrichtung näher beschrieben.

Die Sensor-Wandlerstatorelektroden 44ᵢ sind innerhalb des Rings der Aktuator-Wandler-Statorelektroden 37ᵢ angeordnet. In diesem Bereich sind die absoluten Bewegungen der Kammfinger 46 in Richtung parallel zur Flächennormalen 36 geringer als außerhalb des Rings der Aktuator-Wandler-Statorelektroden 37ᵢ. Der absolute Bewegungsumfang hängt mit dem Abstand zum effektiven Schwenkpunkt 37 zusammen.

Bei den in den Figuren dargestellten Ausführungsformen stehen die Sensor-Wandlerstatorelektroden 44ᵢ in Radialrichtung nach innen über die innere Einhüllende der Aktuator-Wandlerstatorelektroden 37ᵢ hinaus. Es ist auch möglich, die Sensor-Wandlerstatorelektroden 44ᵢ derart auszubilden, dass sie nicht über die innere Einhüllende der Aktuator-Wandlerstatorelektroden 37ᵢ hinausstehen.

Die Sensor-Wandlerstatorelektroden 44ᵢ sind radial relativ zum effektiven Schwenkpunkt 35 ausgebildet und angeordnet. Sie weisen insbesondere in Radialrichtung verlaufenden Kammfinger auf. Hierdurch wird die Sensitivität in Bezug auf eine mögliche thermische Ausdehnung des Einzelspiegels 20 verringert.

Wie bereits vorhergehend erläutert wurde, weist die Sensor-Einrichtung konstruktionsbedingt höchstens eine minimale Sensitivität im Hinblick auf parasitäre Bewegungen des Einzelspiegels 20, insbesondere im Hinblick auf Verlagerungen senkrecht zur Flächennormalen 36 und/oder Rotationen um die Flächennormale 36 auf. Aufgrund des Abschirm-Prinzips der Sensor-Einrichtung weist diese auch höchstens eine minimale Sensitivität im Hinblick auf eine mögliche thermische Ausdehnung des Einzelspiegels 20 auf. Des weiteren weißt das Sensorprinzip eine minimale Sensitivität hinsichtlich thermischer Verbiegung des Spiegels auf.

Jeweils zwei einander bezüglich des effektiven Schwenkpunkts 35 gegenüberliegende Sensor-Einheiten mit jeweils einer Sender-Elektrode 47 und einer Empfänger-Elektrode 48 sind differenziell verschaltet oder zumindest differenziell auslesbar. Dies ermöglicht es, Störungen der Messung der Position des Spiegels 20, insbesondere aufgrund von Eigenmoden des Einzelspiegels 20, zu eliminieren.

Die aktiven Bestandteile der Sensor-Einrichtung sind auf dem Substrat 39 angeordnet. Dies ermöglicht es, den Kippwinkel des Einzelspiegels 20 direkt relativ zum Substrat 39 zu messen. Außerdem kann aufgrund der Anordnung Sender-Elektroden 47 und der Empfänger-Elektroden 48 auf dem Substrat 39 die Länge der Signalleitung 56 und/oder der Versorgungsleitungen 57 reduziert, insbesondere minimiert, werden. Hierdurch werden mögliche Störeinflüsse verringert. Hierdurch werden konstante Betriebsbedingungen sichergestellt.

Die Sender-Elektroden 47 sind jeweils als aktive Abschirmung, insbesondere als Abschirm-Ring um die Empfänger-Elektroden 48 herum ausgebildet. Hierdurch wird ein kapazitives Übersprechen zwischen den Aktuator-Wandler-Statorelektroden 37ᵢ und der Sensor-Einrichtung verringert, insbesondere minimiert, insbesondere verhindert.

Wie in der Fig. 4 schematisch angedeutet ist, wird die Sender-Elektrode 47 mit einer Wechselspannung von einer Spannungsquelle 58 beaufschlagt. Die Spannungsquelle 58 weist eine geringe Impedanz auf. Die Spannungsquelle 58 weist insbesondere eine Ausgangsimpedanz auf, welche im Bereich der Anregungsfrequenz kleiner ist als 1 ‰ der Kopplungskapazitäten von den Aktuator-Wandlerstatorelektroden 37ᵢ zu den Sende-Elektroden 47. Die Ausgangsimpedanz der Spannungsquelle ist kleiner als 1 ‰ der Kapazitäten zwischen den Sender-Elektroden 47 und den Sensor-Wandlerspiegelelektroden 45 beziehungsweise den Empfänger-Elektroden 48. Hierdurch wird sichergestellt, dass die auf die Senderelektroden 47 aufgeprägte Wechselspannung nicht oder zumindest nicht wesentlich von den variablen Aktuatorspannungen U_{A} oder von der variablen Sensorkapazität beeinflusst wird.

Allgemein kann zum Auslesen des Sensor-Wandlers ein Netzwerkanalysator verwendet werden. Mit diesem kann die Impedanz des Sensor-Wandlers bestimmt und daraus mittels eines Umrechnungsfaktors die Verlagerungsposition des Einzelspiegels 20 bestimmt werden. Ein derartiger Netzwerkanalysator umfasst allgemein eine Anregungsquelle, beispielsweise die vorhergehend beschriebene Spannungsquelle 58, und eine Responsemessung, beispielsweise eine Strommessung oder eine Messung der während einer Signalperiode transportierten Ladung. Aus dem Quotienten von Anregungsspannung und Strom kann die Netzwerkimpedanz und damit die Sensorkapazität bestimmt werden.

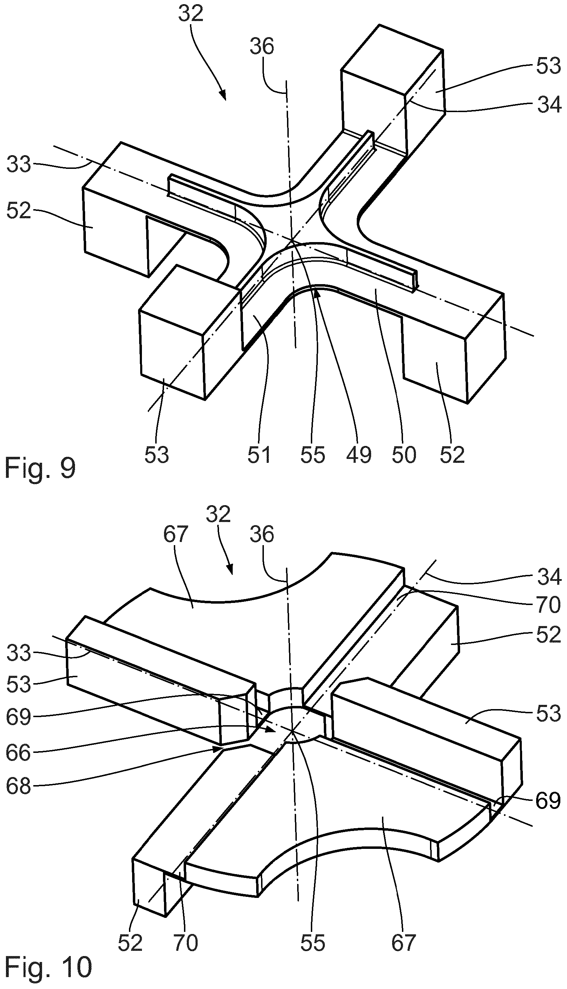

Im Folgenden werden unter Bezugnahme auf die Figuren 9 und 10 zwei Varianten des Gelenks 32 näher beschrieben.

Das Gelenk 32 ist als kardanisches Festkörpergelenk ausgebildet.

Gemäß einer in Fig. 9 dargestellten Variante ist das Gelenk 32 als Torsionsfederelement-Struktur ausgebildet. Es umfasst insbesondere zwei Torsionsfedern 50, 51. Die beiden Torsionsfedern 50, 51 sind einteilig ausgebildet. Sie sind insbesondere senkrecht zueinander ausgerichtet und bilden eine kreuzförmige Struktur 49.

Die Torsionsfedern 50, 51 weisen eine Länge von etwa 100 µm, eine Breite von etwa 60 µm und eine Dicke von etwa 1 µm bis 5 µm auf. Derartige Torsionsfedern 50, 51 eignen sich als Einzelspiegel 20 mit Abmessungen von 0,6 mm · 0,6 mm. Die Abmessungen der Torsionsfedern 50, 51 hängen von den Abmessungen der Einzelspiegel 20 ab. Allgemein benötigen größere Spiegel größere, insbesondere steifere Torsionsfedern 50, 51.

Die Torsionsfeder 50 erstreckt sich in Richtung der Kippachse 33. Die Torsionsfeder 50 ist mechanisch mit dem Substrat 39 verbunden. Zur Verbindung der Torsionsfeder 50 mit dem Substrat 39 dienen Verbindungsblöcke 52. Die Verbindungsblöcke 52 sind jeweils quaderförmig ausgebildet. Sie können auch zylinderförmig, insbesondere kreiszylinderförmig ausgebildet sein. Andere geometrische Formen sind ebenso möglich.

Die Verbindungsblöcke 52 sind jeweils in einem Endbereich der Torsionsfeder 50 angeordnet.

Die Verbindungsblöcke 52 dienen außer der Verbindung des Gelenks 32 mit dem Substrat 39 auch als Distanzstücke zwischen der Torsionsfeder 50 und dem Substrat 39.

Entsprechend der Verbindung der Torsionsfeder 50 mit dem Substrat 39 ist die Torsionsfeder 51 mit dem in Fig. 9 nicht dargestellten Spiegelkörper 27 des Einzelspiegels 20 mechanisch verbunden. Hierfür sind Verbindungsblöcke 53 vorgesehen. Die Verbindungsblöcke 53 entsprechen in ihrer Ausbildung den Verbindungsblöcken 52. Die Verbindungsblöcke 53 sind jeweils in einem Endbereich der Torsionsfeder 51 angeordnet.

Die Verbindungsblöcke 53 und die Verbindungsblöcken 52 sind in Richtung der Flächennormalen 36 auf entgegengesetzten Seiten der kreuzförmigen Struktur 49 angeordnet.

Die Torsionsfedern 50, 51 des Gelenks 32 weisen in dem an den Mittenbereich anschließenden Bereich der Schenkel der kreuzförmigen Struktur 49 ein T-förmiges Profil auf. Die Torsionsfedern 50, 51 sind hierdurch versteift, insbesondere in Bezug auf Auslenkungen in Richtung der Flächennormalen 36. Hierdurch wird erreicht, dass die Eigenfrequenz des Spiegels 20 in Vertikalrichtung zu hohen Frequenzen hin verschoben und somit eine Modenseperation der geregelten

Kippmoden und der parasitären vertikalen Schwingungsmode von mehr als einer Dekade im Frequenzraum erreicht wird, was regelungstechnisch vorteilhaft ist. Außerdem kann durch das kreuzförmige Versteifungselement 55 die Wärmeleitfähigkeit des Gelenks 32 vergrößert werden.

Prinzipiell ist es möglich, ein entsprechendes Versteifungselement 55 auch auf der gegenüberliegenden Seite der kreuzförmigen Struktur 49 anzuordnen. In diesem Fall weisen die Schenkel der Torsionsfedern 50, 51 einen kreuzförmigen Querschnitt auf.

Durch gezieltes Design der Versteifungselemente 55 lassen sich die mechanischen und/oder thermischen Eigenschaften des Gelenks gezielt beeinflussen. Die Profilierung, insbesondere die Versteifungselemente 55, dienen dazu, die Steifigkeit in der Aktuatorebene zu erhöhen. Sie dienen insbesondere dazu, eine Fesselungssteifigkeit des Einzelspiegels 20 gegenüber der Grundplatte 39 in den horizontalen Freiheitsgraden, das heißt einer horizontalen Verschiebung und einer Rotation um die vertikale Achse, zu realisieren. Hierdurch werden die Eigenfrequenzen der parasitären Moden des Einzelspiegels 20 erhöht. Hierdurch wird ein reglungstechnisch günstiger Modenabstand der aktuierten Kippmoden und der parasitären Moden erreicht. Die Eigenfrequenzen der parasitären Moden liegen insbesondere vorzugsweise mindestens eine Dekade oberhalb der aktuierten Kippmoden.

Durch die hohe Horizontalsteifigkeit werden außerdem die zwischen dem Spiegel 20 und dem Aktuator-Wandlerstatorkammfingern 38 wirkenden Kräfte und die hierdurch entstehende elektrostatische Erweichung (negative Steifigkeit) aufzunehmen. Es kann insbesondere sichergestellt werden, dass es aus Sicht der Kammfinger 38 keinen transversalen Pull-in gibt.

Die Versteifungselemente 55, welche auch als Versteifungsrippen, insbesondere als senkrechte Versteifungsrippen bezeichnet werden, dienen dazu, die Durchbiegungssteifigkeit und somit die Eigenfrequenz von vertikalen Schwingungen, das heißt Schwingungen in Richtung der Flächennormalen 36, zu höheren Frequenzen hin zu verschieben.

Das Gelenk 32 ist steif im Hinblick auf Drehungen um die Flächennormale 36. Das Gelenk 32 ist steif im Hinblick auf lineare Verlagerung in Richtung der Flächennormalen 36. Steif bedeutet in diesem Zusammenhang, dass die Eigenfrequenz der Rotationsschwingungen um die Flächennormale 36 beziehungsweise die Eigenfrequenz der Schwingungen in Richtung der Flächennormalen um mehr als eine Frequenzdekade oberhalb der aktuierten Moden liegt. Die aktuierten Kippmoden des Einzelspiegels liegen insbesondere bei Frequenzen unterhalb von 1 kHz, insbesondere unterhalb von 600 Hz. Die Eigenfrequenz der Rotationsschwingungen um die Flächennormale 36 liegt bei mehr als 10 kHz, insbesondere mehr als 30 kHz.

Das Gelenk 32 hat eine bekannte Flexibilität im Hinblick auf Verschwenkungen um die beiden Kippachsen 33, 34. Die Steifigkeit des Gelenks 32 im Hinblick auf Verschwenkungen um die Kippachsen 33, 34 kann durch eine gezielte Ausbildung der Torsionsfedern 50, 51 beeinflusst werden.

Das Gelenk 32, insbesondere die Verbindungsblöcke 52, 53 sowie die Torsionsfedern 50, 51 dienen der Wärmeabfuhr aus dem Spiegelkörper 27. Die Bestandteile des Gelenks 32 bilden Wärmeleitungsabschnitte.

Das Gelenk 32 inklusive der Verbindungsblöcke 52, 53 hat mehrere Funktionen. Erstens: Fesselung der nicht aktuierten Freiheitsgrade, zweitens, Wärmetransport von Spiegel 20 zur Grundplatte 39 und drittens die elektrische Verbindung des Spiegels 20 zur Grundplatte 39. Der Zweck der Blöcke 52, 53 ist primär Platz zu schaffen für die Vertikalbewegung des Gelenkelements. Natürlich müssen dann die Blöcke 52, 53 ebenso die mechanischen, thermischen und elektrischen Funktionen der Federn 50, 51 weitergeben.

Die Torsionsfedern 50, 51 sind aus einem Material mit einem Wärmeleitkoeffizienten von mindestens 50 W/(mK), insbesondere mindestens 100 W/(mK), insbesondere mindestens 140 W/(mK).

Die Torsionsfedern 50, 51 können aus Silizium oder einer Silizium-Verbindung sein. Das Gelenk 32 ist bevorzugt aus hochdotiertem monokristallinem Silizium hergestellt. Dies eröffnet eine Prozesskompatibilität des Herstellungsprozesses mit etablierten MEMS-Fertigungsprozessen. Außerdem führt dies zu einer vorteilhaft hohen thermischen Leitfähigkeit und einer guten elektrischen Leitfähigkeit.

Bei einer absorbierten Leistungsdichte von 10 kW/(m²) und einer Spiegelgröße von 600 µm x 600 µm ergibt sich mit den angegebenen Werten der Abmessungen, insbesondere mit einer Dicke der Torsionsfedern 50, 51 von 4 µm, und der Wärmeleitfähigkeit der Torsionsfedern 50, 51 ein Temperaturunterschied zwischen dem Spiegelkörper 27 und dem Substrat 39 von 11 K.

Die Torsionsfedern 50, 51 können auch eine geringere Dicke aufweisen. Bei einer Dicke der Torsionsfedern 50, 51 von 2,4 µm ergibt sich - bei ansonsten gleichen Parameterwerten - ein Temperaturunterschied zwischen dem Spiegelkörper 27 und dem Substrat 39 von 37 K.

Die Wärmeleitfähigkeit der Torsionsfeder liegt insbesondere im Bereich von 0,5 K/kW/m² bis 10 k/kW/m², wobei sich die Wärmeleistungsdichte auf die mittlere vom Spiegel absorbierte Wärmeleistung bezieht. Mit derartigen Torsionsfedern könnte erreicht werden, dass der Temperaturunterschied zwischen dem Spiegelkörper 27 und dem Substrat 39 weniger als 50 K, insbesondere weniger als 40 K, insbesondere weniger als 30 K, insbesondere weniger als 20 K beträgt.

Bei der in Fig. 10 dargestellten Variante des Gelenks 32 sind anstelle der Torsionsfedern 50, 51 zwei Paare von Biegefedern 69, 70 vorgesehen. Auch bei dieser Alternative weist das Gelenk 32 eine große Steifigkeit in den horizontalen Freiheitsgraden auf. Diesbezüglich wird auf die Beschreibung der in Fig. 9 dargestellten Alternative verwiesen. Die Designaspekte im Hinblick auf die Horizontalsteifigkeit sowie im Hinblick auf die Modenseparation der parasitären Eigenmoden entsprechen ebenfalls den vorhergehend beschriebenen.

Bei der in Fig. 10 dargestellten Variante des Gelenks 32 handelt es sich um ein kardanisches Festkörpergelenk mit orthogonal angeordneten, horizontalen, als Blattfedern ausgeführten Biegefedern 69, 70. Jeweils zwei der Biegefedern 69, 70 sind mittels einer plattenförmigen Struktur 67, welche auch als Zwischenplatte bezeichnet wird, miteinander verbunden.

Horizontale Blattfedern sind prozesstechnisch günstig. Sie erleichtern insbesondere die Herstellung des Gelenks 32.

Bei der Variante gemäß Fig. 10 sind die Verbindungsblöcke 52, 53 jeweils länglich, stabförmig ausgebildet. Sie erstrecken sich im Wesentlichen über die gesamte Ausdehnung des Gelenks 32 in Richtung der Kippachsen 33, 34.

Zwischen zwei der Verbindungsblöcke 52, 53 ist jeweils ein Trennschlitz 68 vorgesehen. Das Gelenk 32 ist somit zweiteilig ausgebildet.

Das Gelenk 32 ist vorzugsweise achsensymmetrisch zur Flächennormalen 36 ausgebildet. Es weist somit eine zweizählige Drehsymmetrie auf. Insbesondere die Biegefedern 69 und 70 sind jeweils spiegelsymmetrisch zur Flächennormalen 36 ausgebildet.

Bei der Variante gemäß Fig. 10 ist das Versteifungselement 55 in Form von zwei plattenförmigen Strukturen 67 ausgebildet. Die plattenförmigen Strukturen 67 sind insbesondere parallel zu der durch die Schwenkachsen 33, 34 definierten Ebene angeordnet. Die plattenförmigen Strukturen 67 verbinden die durch die Biegefedern 60, 70 realisierten Schwenkachsen 33, 34. Die Schwenkachsen 33, 34 sind insbesondere orthogonal zueinander ausgerichtet.

Bei dieser Alternative weist das Gelenk 32 in einem Zentralbereich eine Aussparung 66 auf. Die Aussparung 66 ermöglicht es, im Zentralbereich des Einzelspiegels 20, insbesondere im Bereich der Flächennormalen 36, weitere Bauelemente, beispielsweise ein Gegengewicht, am Spiegelkörper 27 anzuordnen, ohne dass dies zu einer Kollision mit dem Gelenk 32 führen würde. Eine entsprechende Aussparung 66 kann auch bei der Variante gemäß Fig. 9 vorgesehen sein.

Die beiden plattenförmigen Strukturen 67 können auch im Zentralbereich miteinander verbunden sein. Hierdurch kann eine noch höhere Steifigkeit des Gelenks 32 in Vertikalrichtung, das heißt in Richtung der Flächennormalen 36, erreicht werden.

Im Folgenden werden weitere Aspekte, insbesondere thermische Aspekte, des optischen Bauelements 30 beschrieben.

Die Sender-Elektroden 47 und die Empfänger-Elektroden 48 stehen in thermischem Kontakt mit dem Substrat 39. Das Substrat 39 dient als Wärmesenke. Sowohl die Sender-Elektroden 47 als auch die Empfänger-Elektroden 48 befinden sich somit auf derselben oder zumindest im Wesentlichen auf derselben Temperatur wie das Substrat 39. Auch die aktiven Aktuator-Wandler-Statorelektroden 37ᵢ stehen in thermischem Kontakt mit dem Substrat 39. Auch sie weisen vorzugsweise beim Betrieb der Verlagerungs-Einrichtung 31 im Wesentlichen dieselbe Temperatur auf, wie das Substrat 39. Die Temperatur der Sensor-Wandlerstatorelektroden 44ᵢ ist somit während des Betriebs des optischen Bauelements 30 im Wesentlichen konstant. Sie ist insbesondere unabhängig von der Temperatur des Einzelspiegels 20. Potentielle Schwankungen der Temperatur des Substrats 39 können kompensiert werden. Sie können insbesondere auf wesentlich einfachere Weise kompensiert werden als Temperaturschwankungen des Einzelspiegels 20.

Das optische Bauelement 30, das im Bereich der Flächennormalen 36 liegt, weist ein thermisches Zentrum 59 liegt. Ein Wärmefluss verläuft im Wesentlichen in Radialrichtung nach außen.

Die Sensor-Wandlerstatorelektroden 44ᵢ sind radial symmetrisch zum thermischen Zentrum 59 angeordnet. Eine thermische Ausdehnung des Einzelspiegels 20 führt lediglich zu einer radialen Verschiebung der Kammfinger 46. Hiergegen ist die Sensoreinrichtung im Wesentlichen insensitiv.

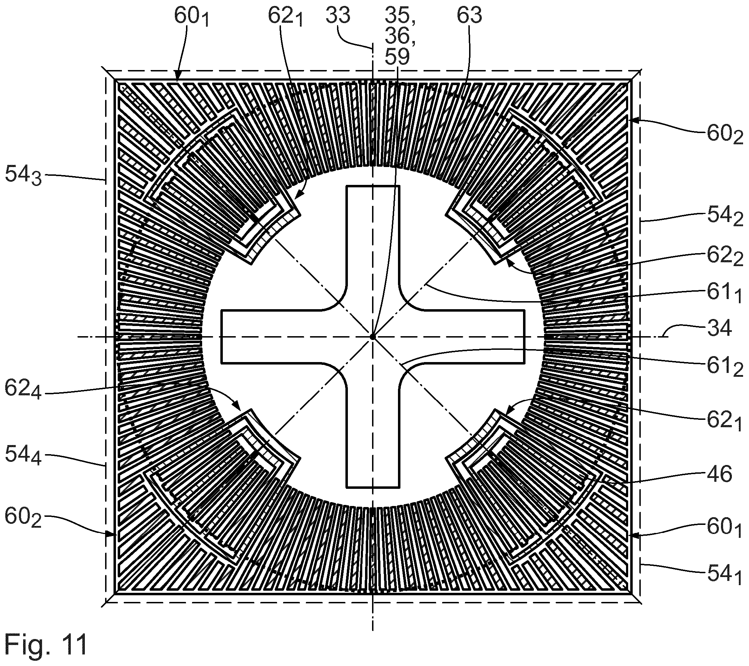

Im Folgenden werden unter Bezugnahme auf die Fig. 11 weitere Aspekte, Ausbildung und Anordnung der Aktuator-Wandler-Statorelektroden 37ᵢ und der Sensor-Wandlerstatorelektroden 44ᵢ beschrieben.

Jeweils zwei einander bezüglich des effektiven Schwenkpunkts 35 gegenüberliegende Aktuator-Wandler-Statorelektroden 37ᵢ bilden ein Elektrodenpaar 60₁, 60₂. Die Elektrodenpaare 60₁, 60₂ sind differenziell angesteuert. Die Elektrodenpaare 60ᵢ, 60₂ können über den gesamten Bewegungsbereich des Einzelspiegels 20 differenziert angesteuert werden. Alternativ hierzu kann grundsätzlich auch im Zentrum überblendet werden. Sie dienen der Verkippung des Einzelspiegels 20 um Aktuator-Achsen 61₁, 61₂, die Aktuator-Achsen 61₁, 61₂ verlaufen entlang der Diagonalen des optischen Bauelements 30, insbesondere parallel zu den Diagonalen des Spiegelkörpers 27 des Einzelspiegels 20. Die Aktuator-Achsen 61₁, 61₂ werden durch die in den Quadranten 54₁ und 54₃ beziehungsweise 54₂ und 54₄ angeordneten Aktuator-Wandlerelektroden 37ᵢ, 42 definiert. Die Aktuator-Achsen 61₁, 61₂ sind jeweils um 45° gegen die durch das Gelenk 32 definierten Kippachsen 33, 34 verdreht angeordnet.

Die Sensor-Wandlerstatorelektroden 44ᵢ sind entlang der Diagonalen des Substrats 39 angeordnet. Jeweils zwei einander bezüglich des effektiven Schwenkpunkts 35 gegenüberliegende Sensor-Wandlerstatorelektroden 44ᵢ bilden ein Elektrodenpaar 62₁, 62₂. Die Sensor-Wandlerstatorelektroden 44ᵢ der Elektrodenpaare 62₁, 62₂ sind differenziell verschaltet. Sie dienen der Bestimmung der Kipp- oder Verschwenkposition relativ zu den Aktuator-Achsen 61₁, 61₂. Jeweils eines der Elektrodenpaare 62₁, 62₂ der Sensoreinrichtung ist einem der Elektrodenpaare 60₁, 60₂ der Aktuator-Wandler-Statorelektroden 37ᵢ zugeordnet und entsprechend wie dieses ausgerichtet.

Alle Wandler Elektroden 37ᵢ, 42ᵢ, 44ᵢ, 45 sind als Kamm Elektroden mit mehreren Kammfingern ausgeführt wobei die jeweils komplementären Kammfinger von Spiegel und Stator ineinander greifen und somit einen Kondensator bilden, dessen Kapazität weitgehend linear von der Eintauchtiefe abhängt.

Sämtliche Kammfinger der Verlagerungs-Einrichtung 31, insbesondere sämtlich Kammfinger der Aktuator-Wandler-Statorelektroden 37ᵢ, der Aktuator-Spiegelelektrode 42 sowie der Sensor-Wandlerstatorelektroden 44ᵢ und der Sensor-Wandlerspiegelelektrode 45 weisen dieselben Abmessung in Richtung der Flächennormalen 36 auf. Diese erleichtert unter anderem die Herstellung derselben. Es ist insbesondere möglich, die gesamte Elektrodenstruktur, welche auf dem Substrat 39 angeordnet ist und/oder die gesamte Elektrodenstruktur, welche mit dem Spiegelkörper 27 verbunden ist, in ein und derselben Abfolge von Prozessschritten herzustellen.

Sämtliche aktive Aktuator-Wandler-Statorelektroden 37ᵢ sind in thermischem Kontakt mit dem Substrat 39. Ihre Temperatur beim Betrieb der Verlagerungs-Einrichtung 31 entspricht somit im Wesentlichen der Temperatur des Substrats 39. Dies führt zu verbesserten, im Wesentlichen konstanten, Betriebsbedingungen.

Der Spiegelkörper 27 ist elektrisch geerdet. Ein hierfür benötigter elektrisch leitfähiger Kontakt wird durch das Gelenk 32 hergestellt. Alternativ kann der Spiegelkörper 27 über das Gelenk 32 mit einer definierten Biasspannung beaufschlagt werden um einen anderen Betriebspannungs-Arbeitspunkt oder Bereich für Aktuatoren und Sensoren einzustellen.

In der Fig. 11 ist zur Verdeutlichung ein Austauchkreis 63 eingezeichnet. Der Austauchkreis 63 umgrenzt den Bereich innerhalb dessen es auch bei einer maximalen Verkippung des Einzelspiegels 20 nicht zu einem Austauchen der Aktuator-Spiegelelektrode 42 aus den Aktuator-Wandler-Statorelektroden 37ᵢ bzw. zu einem Austauchen der Kammfinger 46 aus den Sensor-Wandlerstatorelektroden 44ᵢ kommt. Außerhalb des Austauchkreises 63 kann es zu einem Austauchen der Aktuator-Spiegelelektrode 42 aus den Aktuator-Wandler-Statorelektroden 37ᵢ kommen.

Vorzugsweise sind sämtlich der Kammfinger 46 der Sensor-Einrichtung innerhalb des Austauchkreises 63 angeordnet. Die Kammfinger 46 tauchen somit in keiner möglichen Kippposition des Einzelspiegels 20 aus den Sensor-Wandlerstatorelektroden 44ᵢ aus. Sie tauchen insbesondere nie vollständig aus den Sensor-Wandlerstatorelektroden 44ᵢ aus. Hierdurch wird sichergestellt, dass die Verkippposition des Einzelspiegels 20 mithilfe der Sensor-Einrichtung stets zuverlässig ermittelt werden kann.

Vorzugsweise weist der Austauchkreis 63 einen Durchmesser auf, welcher im Wesentlichen der Seitenlänge der Reflexionsfläche 26 des Einzelspiegels 20 entspricht. Er kann auch etwas größer sein. Sofern der Austauchkreis 63 einen Durchmesser aufweist, welcher gerade der Diagonalen der Reflexionsfläche 26 des Einzelspiegels 20 entspricht, wird ein Austauchen der Aktuator-Spiegelelektrode 42 aus den Aktuator-Wandler-Statorelektroden 37ᵢ vollständig vermieden. Dies kann vorteilhaft sein, ist jedoch nicht zwingend notwendig.

Der Radius des Austauchkreises 63 hängt vom geforderten maximalen Kippwinkelbereich und vom Kammüberlapp der Kammfinger ab.

Die maximal mögliche Kippposition des Einzelspiegels 20 kann durch mechanische Elemente, insbesondere durch Anschlags-Elemente, begrenzt werden. Derartige Anschlags-Elemente können auf dem Substrat 39 angeordnet sein. Sie sind vorzugsweise randseitig, d. h. außerhalb der Elektrodenstruktur der Verlagerungs-Einrichtung 31 angeordnet.

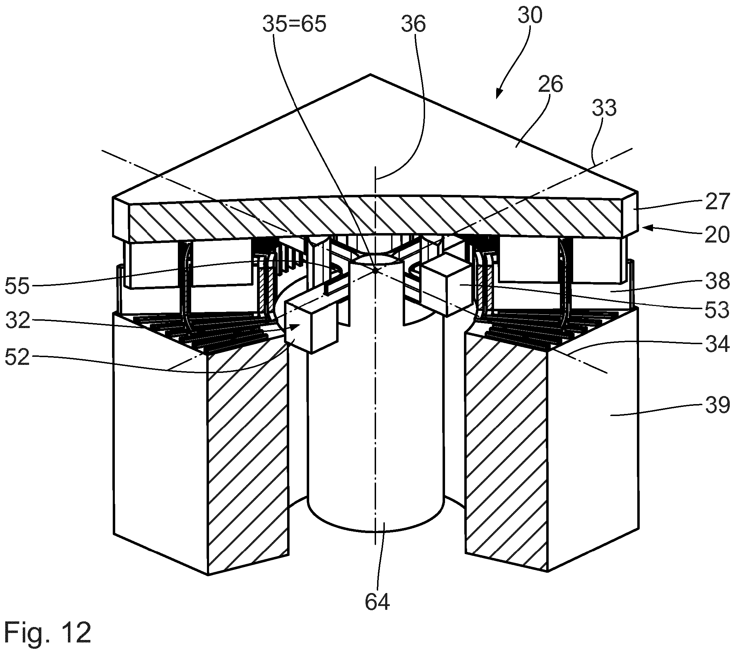

Im Folgenden wird unter Bezugnahme auf die Fig. 12 eine weitere Variante des optischen Bauelements 30 beschrieben. Das optische Bauelement 30 gemäß der in der Fig. 12 schematisch dargestellten Variante entspricht einer der vorhergehend beschriebenen Varianten, auf die hiermit verwiesen wird.

Gemäß der in Fig. 12 schematisch dargestellten Variante ist vorgesehen, auf der dem Gelenk 32 in Richtung der Flächennormalen 36 gegenüberliegenden Seite des Spiegelkörpers 27 ein Ausgleichsgewicht 64 anzuordnen. Das Ausgleichsgewicht 64 ist fix mit dem Spiegelkörper 27 verbunden. Es ist insbesondere direkt mit dem Spiegelkörper 27 verbunden.

Das Ausgleichsgewicht 64 ist derart ausgebildet und angeordnet, dass der Massenschwerpunkt 65 des mechanischen Systems, welches sämtliche zusammen mit dem Spiegelkörper 27 des Einzelspiegels 20 beweglichen Bestandteile des optischen Bauelements 30 umfasst, gerade mit dem effektiven Schwenkpunkt 35 zusammenfällt. Durch eine gezielte Ausbildung und Anordnung des Ausgleichsgewichts 64 kann der Massenschwerpunkt 65 gezielt verlagert werden. Durch eine Verlagerung des Massenschwerpunkts 65 derart, dass seine Position mit der des effektiven Schwenkpunkts 35 zusammenfällt, lässt sich die Sensitivität des Einzelspiegels gegenüber externen Störungen erheblich verringern. Außerdem werden parasitäre Eigenmoden in einem Hochfrequenz-Bereich gehalten, welcher ausreichend weit vom Frequenzspektrum, welches bei einer Verlagerung des Einzelspiegels 20 mittels der Aktuator-Einrichtung auftreten, entfernt sind.

Mittels des Ausgleichsgewichts 64 kann erreicht werden, dass der Massenschwerpunkt 65 des mechanischen Systems, welcher prinzipbedingt aus dem effektiven Schwenkpunkt 35 des Gelenks 32 herausverschoben sein kann, in den effektiven Schwenkpunkt 35 zurückverschoben wird.

Das Ausgleichsgewicht 64 kann in Richtung der Flächennormalen 36 eine Länge von bis zu 500 µm aufweisen.

Vorzugsweise weist das Ausgleichsgewicht 64 eine Rotationssymmetrie bezüglich der Flächennormalen 36 auf. Es kann insbesondere zylinderförmig, insbesondere kreiszylinderförmig ausgebildet sein. Es kann auch, abgesehen von einem Verbindungsstück, mittels welchem es mit dem Spiegelkörper 27 mechanische verbunden ist, im Wesentlichen kugelförmig ausgebildet sein.

Das Ausgleichsgewicht 64 weist insbesondere eine Drehsymmetrie entsprechend der Drehsymmetrie des Gelenks 32 auf.

Das Ausgleichsgewicht 64 kann kreissektorförmige Aussparungen aufweisen. Es kann außerdem einen sich in Richtung der Flächennormalen 36 erstreckenden Zentralhohlraum aufweisen. Dieser Hohlraum ermöglicht einen Zugang zum Material unter dem Gelenk 32. Dieses Material kann, sofern notwendig, als Opfermaterial entfernt werden.

Durch die Anordnung des Ausgleichsgewichts 64, insbesondere durch die Verlagerung des Massenschwerpunkts 65 des mechanischen Systems, so dass dieser mit dem effektiven Schwenkpunkt 35 zusammenfällt, wird erreicht, dass sich Beschleunigungen in Horizontalrichtung, welche beispielsweise durch mechanische Vibrationen verursacht werden können, nicht in Kippmomente übersetzt werden, die sich störend auf die eingestellte Spiegelposition auswirken. Durch das Ausgleichsgewicht 64 kann der Einzelspiegel 20 unempfindlicher gegenüber Vibrationsanregungen gemacht werden. Es wird insbesondere die Kippwinkelstabilität bei einem gegebenen Vibrationsspektrum verbessert. Die Anordnung des Ausgleichsgewichts 64 bildet mit anderen Worten eine Maßnahme zur Reduktion der Spiegelempfindlichkeit gegenüber Störungen.

In einer besonders vorteilhaften Variante kann das Ausgleichsgewicht 64 gleichzeitig ein Anschlagselement, insbesondere einen sogenannten End-Stopp, durch welchen eine maximal mögliche Verkippung des Einzelspiegels 20 begrenzt wird. Hierdurch kann der Einzelspiegel 20 vor mechanischen Schäden und/oder einem elektrischen Kurzschluss geschützt werden. Durch eine Ausbildung des Ausgleichsgewichts 64 als Anschlagselement kann es gleichzeitig als mechanische Referenz für die Spiegelkippung verwendet werden. Es ist insbesondere möglich, mittels Endanschlagspforte die Sensor-Einrichtung auf eine mögliche Drift zu überprüfen und/oder nachzukalibrieren. Dies ermöglicht es, auf ein externes Messsystem zu verzichten. Dies erleichtert die Überprüfung und/oder Kalibrierung der Sensor-Einrichtung erheblich.

Andererseits ist das Ausgleichsgewicht 64 derart ausgebildet und angeordnet, das es innerhalb des möglichen Verlagerungsbereichs des Einzelspiegels 20 berührungsfrei zum Substrat 39 sowie den Bestandteilen der Verlagerungs-Einrichtung 31 ist. Für das Ausgleichsgewicht 64 kann eine spezielle Aussparung im Substrat 39 vorgesehen sein. Die Ausnehmung für das Ausgleichsgewicht 64 ist insbesondere im Inneren der ringförmigen Elektrodenstruktur angeordnet.

Die unterschiedlichen Varianten der Verlagerungs-Einrichtung 31, der Sensor-Einrichtung, des Gelenks 32 und der übrigen Bestandteile des optischen Bauelements 30 können im Wesentlichen frei miteinander kombiniert werden.

Gemäß einer weiteren Variante können die Aktuatoren gleichzeitig auch als Sensoren genutzt werden. Hierzu ist vorgesehen, die kippwinkelabhängige Aktuatorkapazität bei einer Frequenz, welche deutlich höher, insbesondere mindestens eine Dekade höher liegt als die Aktuierungsfrequenz (Regelbandbreite), auszulesen. Auf eine separate Sensor-Einrichtung kann in diesem Fall verzichtet werden. Es ist auch möglich, zusätzlich eine dedizierte separate Sensor-Einrichtung, insbesondere gemäß der vorhergehenden Beschreibung, vorzusehen.

Die Verlagerungs-Einrichtung 31 ist vorzugsweise mittels eines MEMS-Verfahrens herstellbar.

Sie weist insbesondere ein Design auf, welches auf eine Fertigung mit MEMS-Verfahrensschritten ausgelegt ist. Sie weist insbesondere vornehmlich, insbesondere ausschließlich, horizontale Schichten, welche vertikal strukturiert sein können, auf.

Insbesondere die Elektroden 37ᵢ, 42, 44ᵢ, 45 sind mittels MEMS-Verfahrensschritten herstellbar. Auch das Gelenk 32 ist vorzugsweise mittels MEMS-Verfahrensschritten herstellbar.

## Patentansprüche

1. Sensor-Einrichtung zur direkten Erfassung der Verschwenkposition eines Spiegel-Elements (20) mit zwei Schwenk-Freiheitsgraden umfassend
1.1. mindestens eine Sensor-Elektrodenstruktur mit
1.1.1. einer Sender-Elektrode (47) mit einer Kammstruktur und
1.1.2. einer Empfänger-Elektrode (48) mit einer Kammstruktur,
1.2. eine Spannungsquelle (58) zur Beaufschlagung der Sender- Elektrode (47) mit einer Wechselspannung,
1.3. und eine Abschirm-Einheit (45) zur variablen Abschirmung der Empfänger-Elektrode (48) von der Sensor-Elektrode (47),
1.4. wobei sämtliche Sender-Elektroden (47) und sämtliche Empfänger-Elektroden (48) in einer gemeinsamen Ebene angeordnet sind,
1.5. wobei die Abschirm-Einheit (45) eine Kammstruktur aufweist, und
1.6. wobei die Abschirm-Einheit (45) derart relativ zur Sender- und Empfänger-Elektrode (47, 48) der Sensor-Elektrodenstruktur angeordnet ist, dass eine Abschirmung von beiden durch Eintauchen der Abschirm-Einheit zwischen den Kammstrukturen dieser Elektroden bewirkt wird.

2. Sensor-Einrichtung gemäß Anspruch 1, **dadurch gekennzeichnet, dass** die Sensor-Einrichtung eine Mehrzahl von differenziellen Sensor-Paaren aufweist, wobei jedes Sensorpaar eine Messachse definiert, entlang welcher die Verschwenkposition des Spiegel-Elements (20) erfasst wird.

3. Sensor-Einrichtung gemäß Anspruch 2, **dadurch gekennzeichnet, dass** als differentielle Sensoren longitudinale kapazitive Kammwandler dienen.

4. Sensor-Einrichtung gemäß einem der vorherigen Ansprüche, **dadurch gekennzeichnet, dass** die Abschirm-Einheit (45) durch mit einem Spiegelkörper (27) des Spiegel-Elements (20) mechanisch verbundene Bestandteile der Sensor-Einrichtung gebildet ist.

5. Sensor-Einrichtung gemäß einem der vorherigen Ansprüche, **dadurch gekennzeichnet, dass** die Sender-Elektrode (47) und die Empfänger-Elektrode (48) jeweils ortsfest angeordnet sind.

6. Sensor-Einrichtung gemäß einem der vorhergehenden Ansprüche, **dadurch gekennzeichnet, dass** die Sender-Elektrode (47) ein Abschirm-Element bildet.

7. Sensor-Einrichtung gemäß einem der vorhergehenden Ansprüche, **dadurch gekennzeichnet, dass** die Sender-Elektrode (47) einen umfangsseitig geschlossenen Bereich aufweist, welcher die Empfänger-Elektrode (48) in einer Ebene vollständig umgibt.

8. Verlagerungs-Einrichtung (31) zur Verschwenkung eines Spiegel-Elements (20) mit zwei Schwenk-Freiheitsgraden umfassend
8.1. eine Elektrodenstruktur mit Aktuator-Elektroden (37ᵢ, 42),
8.2. wobei die Aktuator-Elektroden (37ᵢ, 42) als Kammelektroden ausgebildet sind,
8.3. wobei sämtliche aktiven Aktuator-Elektroden (37ᵢ) in einer einzigen Ebene angeordnet sind, und
8.4. wobei die Aktuator-Elektroden (37ᵢ, 42) einen Direktantrieb zur Verschwenkung des Spiegel-Elements (20) bilden und,
8.5. eine Sensor-Einrichtung gemäß einem der vorhergehenden Ansprüche.

9. Verlagerungs-Einrichtung (31) gemäß Anspruch 8, **dadurch gekennzeichnet, dass** das Spiegel-Element (20) mittels eines kardanischen Festkörpergelenks (32) gelagert ist.

10. Verlagerungs-Einrichtung (31) gemäß einem der Ansprüche 8 oder 9, **dadurch gekennzeichnet, dass** die Aktuator-Elektroden (37ᵢ, 42) radial angeordnet sind.

11. Verlagerungs-Einrichtung (31) gemäß einem der Ansprüche 8 bis 10, **dadurch gekennzeichnet, dass** die Elektrodenstruktur eine Radiärsymmetrie aufweist.

12. Verlagerungs-Einrichtung (31) gemäß einem der Ansprüche 8 bis 11, **dadurch gekennzeichnet, dass** sämtliche aktiven Aktuator-Elektroden (37ᵢ) ortsfest auf einer Tragestruktur (39) angeordnet sind.

13. Verlagerungs-Einrichtung (31) gemäß einem der Ansprüche 8 bis 12, **dadurch gekennzeichnet, dass** die Elektrodenstruktur Sensor-Elektroden (47, 48) umfasst, welche in derselben Ebene angeordnet sind wie die aktiven Aktuator-Elektroden (37ᵢ).

14. Verlagerungs-Einrichtung (31) gemäß einem der Ansprüche 8 bis 13, **dadurch gekennzeichnet, dass** zumindest eine Teilmenge der aktiven Aktuator-Elektroden (37ᵢ) gleichzeitig als Sensor-Elektroden (47, 48) dient.

15. Optisches Bauelement (30) umfassend
15.1. mindestens einen Mikrospiegel (20) mit zwei Schwenk-Freiheitsgraden und
15.2. eine Verlagerungs-Einrichtung (31) gemäß einem der Ansprüche 8 bis 14 zur Verlagerung des mindestens einen Mikrospiegels (20) oder eine Sensor-Einrichtung gemäß einem der Ansprüche 1 bis 7.

16. Optisches Bauelement (30) gemäß Anspruch 15, **dadurch gekennzeichnet, dass** der mindestens eine Mikrospiegel (20) mittels eines Gelenks (32) mit mindestens zwei Kipp-Freiheitsgraden gelagert ist.

17. Optisches Bauelement (30) gemäß Anspruch 16, **dadurch gekennzeichnet, dass** der Mikrospiegel (20) einen Schwerpunkt aufweist, dessen Position gerade mit einem durch das Gelenk (32) definierten effektiven Drehpunkt zusammenfällt.

18. Spiegel-Array (19) umfassend eine Mehrzahl optischer Bauelemente (30) gemäß einem der Ansprüche 15 bis 17.

19. Beleuchtungsoptik (4) für eine Projektionsbelichtungsanlage (1) zur Führung von Beleuchtungsstrahlung (10) zu einem Objektfeld (5) umfassend mindestens ein Spiegel-Array (19) gemäß Anspruch 18.

20. Beleuchtungssystem (2) für eine Projektionsbelichtungsanlage (1) umfassend
20.1. eine Beleuchtungsoptik (4) gemäß Anspruch 19 und
20.2. eine Strahlungsquelle (3).

21. Projektionsbelichtungsanlage (1) für die Mikrolithographie umfassend
21. 1. eine Beleuchtungsoptik (4) gemäß Anspruch 19 und
21.2. eine Projektionsoptik (7) zur Projizierung eines in einem Objektfeld (5) angeordneten Retikels in ein Bildfeld (8).

## Claims

1. Sensor device for directly capturing the pivot position of a mirror element (20) with two degrees of freedom of pivoting, comprising
1.1.at least one sensor electrode structure comprising
1.1.1.a transmitter electrode (47) with a comb structure and
1.1.2. a receiver electrode (48) with a comb structure,
1.2.a voltage source (58) for applying AC voltage to the transmitter electrode (47),
1.3.and a shielding unit (45) for variable shielding of the receiver electrode (48) from the sensor electrode (47),
1.4. wherein all transmitter electrodes (47) and all receiver electrodes (48) are arranged in a common plane,
1.5. wherein the shielding unit (45) has a comb structure, and
1.6. wherein the shielding unit (45) is arranged relative to the transmitter electrode and receiver electrode (47, 48) of the sensor electrode structure in such a way that a shielding from both is effectuated by immersing the shielding unit between the comb structures of these electrodes.

2. Sensor device according to Claim 1, **characterized in that** the sensor device comprises a plurality of differential sensor pairs, wherein each sensor pair defines a measurement axis, along which the pivot position of the mirror element (20) is captured.

3. Sensor device according to Claim 2, **characterized in that** longitudinal capacitive comb transducers serve as differential sensors.

4. Sensor device according to any one of the preceding claims, **characterized in that** the shielding unit (45) is formed by constituent parts of the sensor device that are mechanically connected to a mirror body (27) of the mirror element (20).

5. Sensor device according to any one of the preceding claims, **characterized in that** the transmitter electrode (47) and the receiver electrode (48) are each arranged in a stationary manner.

6. Sensor device according to any one of the preceding claims, **characterized in that** the transmitter electrode (47) forms a shielding element.

7. Sensor device according to any one of the preceding claims, **characterized in that** the transmitter electrode (47) has a region that is circumferentially closed and completely surrounds the receiver electrode (48) in a plane.

8. Displacement device (31) for pivoting a mirror element (20) with two degrees of freedom of pivoting, comprising
8.1. an electrode structure comprising actuator electrodes (37ᵢ, 42),
8.2. wherein the actuator electrodes (37ᵢ, 42) are embodied as comb electrodes,
8.3. wherein all active actuator electrodes (37ᵢ) are arranged in a single plane, and
8.4. wherein the actuator electrodes (37ᵢ, 42) form a direct drive for pivoting the mirror element (20) and,
8.5. a sensor device according to any one of the preceding claims.

9. Displacement device (31) according to Claim 8, **characterized in that** the mirror element (20) is mounted by means of a Cardan-type flexure (32).

10. Displacement device (31) according to either of Claims 8 and 9, **characterized in that** the actuator electrodes (37ᵢ, 42) are arranged radially.

11. Displacement device (31) according to any one of Claims 8 to 10, **characterized in that** the electrode structure has a radial symmetry.

12. Displacement device (31) according to any one of Claims 8 to 11, **characterized in that** all active actuator electrodes (37ᵢ) are arranged in a stationary manner on a carrying structure (39).

13. Displacement device (31) according to any one of Claims 8 to 12, **characterized in that** the electrode structure comprises sensor electrodes (47, 48) which are arranged in the same plane as the active actuator elements (37ᵢ) .

14. Displacement device (31) according to any one of Claims 8 to 13, **characterized in that** at least a subset of the active actuator electrodes (37ᵢ) simultaneously serves as sensor electrodes (47, 48).

15. Optical component (30), comprising
15.1. at least one micromirror (20) with two degrees of freedom of pivoting and
15.2. a displacement device (31) according to any one of Claims 8 to 14 for displacing the at least one micromirror (20) or a sensor device according to any one of Claims 1 to 7.

16. Optical component (30) according to Claim 15, **characterized in that** the at least one micromirror (20) is mounted by means of a joint (32) with at least two degrees of freedom of tilting.

17. Optical component (30) according to Claim 16, **characterized in that** the micromirror (20) has a centroid, the position of which, to all intents and purposes, coincides with an effective point of rotation that is defined by the joint (32).

18. Mirror array (19), comprising a plurality of optical components (30) according to any one of Claims 15 to 17.

19. Illumination optical unit (4) for a projection exposure apparatus (1) for guiding illumination radiation (10) to an object field (5), comprising at least one mirror array (19) according to Claim 18.

20. Illumination system (2) for a projection exposure apparatus (1), comprising
20.1. an illumination optical unit (4) according to Claim 19 and
20.2. a radiation source (3).

21. Microlithographic projection exposure apparatus (1) comprising
21.1. an illumination optical unit (4) according to Claim 19 and
21.2. a projection optical unit (7) for projecting a reticle that is arranged in an object field (5) into an image field (8).

## Revendications

1. Dispositif capteur pour la détection directe de position de pivotement d'un élément miroir (20) présentant deux degrés de liberté de pivotement, comprenant
1.1. au moins une structure d'électrodes de capteur comportant
1.1.1. une électrode émettrice (47) présentant une structure en peigne et
1.1.2. une électrode réceptrice (48) présentant une structure en peigne,
1.2. une source de tension (58) pour l'application d'une tension alternative à l'électrode émettrice (47),
1.3. et une unité de blindage (45) pour le blindage variable de l'électrode réceptrice (48) vis-à-vis de l'électrode de capteur (47),
1.4. toutes les électrodes émettrices (47) et toutes les électrodes réceptrices (48) étant disposées dans un plan commun,
1.5. l'unité de blindage (45) présentant une structure en peigne, et
1.6. l'unité de blindage (45) étant disposée par rapport aux électrodes émettrice et réceptrice (47, 48) de la structure d'électrodes de capteur de telle sorte qu'un blindage des deux est provoqué par l'insertion de l'unité de blindage entre les structures en peigne de ces électrodes.

2. Dispositif capteur selon la revendication 1, **caractérisé en ce que** le dispositif capteur comporte une pluralité de paires de capteurs différentiels, chaque paire de capteurs définissant un axe de mesure le long duquel la position de pivotement de l'élément miroir (20) est détectée.

3. Dispositif capteur selon la revendication 2, **caractérisé en ce que** des transducteurs en peigne capacitifs longitudinaux servent de capteurs différentiels.

4. Dispositif capteur selon l'une des revendications précédentes, **caractérisé en ce que** l'unité de blindage (45) est formée par des composants du dispositif capteur qui sont reliés mécaniquement à un corps de miroir (27) de l'élément miroir (20).

5. Dispositif capteur selon l'une des revendications précédentes, **caractérisé en ce que** l'électrode émettrice (47) et l'électrode réceptrice (48) sont respectivement disposées de manière fixe.

6. Dispositif capteur selon l'une des revendications précédentes, **caractérisé en ce que** l'électrode émettrice (47) forme un élément de blindage.

7. Dispositif capteur selon l'une des revendications précédentes, **caractérisé en ce que** l'électrode émettrice (47) présente une zone fermée sur sa périphérie, laquelle entoure complètement l'électrode réceptrice (48) dans un plan.

8. Dispositif de déplacement (31) pour le pivotement d'un élément miroir (20) présentant deux degrés de liberté de pivotement, comprenant
8.1. une structure d'électrodes comprenant des électrodes d'actionnement (37ᵢ, 42),
8.2. les électrodes d'actionnement (37ᵢ, 42) étant réalisées sous forme d'électrodes en peigne,
8.3. toutes les électrodes d'actionnement actives (37ᵢ) étant disposées dans un seul plan, et
8.4. les électrodes d'actionnement (37ᵢ, 42) formant un entraînement direct pour le pivotement de l'élément miroir (20), et
8.5. un dispositif capteur selon l'une des revendications précédentes.

9. Dispositif de déplacement (31) selon la revendication 8, **caractérisé en ce que** l'élément miroir (20) est monté au moyen d'une articulation monolithique à cardan (32).

10. Dispositif de déplacement (31) selon l'une des revendications 8 ou 9, **caractérisé en ce que** les électrodes d'actionnement (37ᵢ, 42) sont disposées radialement.

11. Dispositif de déplacement (31) selon l'une des revendications 8 à 10, **caractérisé en ce que** la structure d'électrodes présente une symétrie radiale.

12. Dispositif de déplacement (31) selon l'une des revendications 8 à 11, **caractérisé en ce que** toutes les électrodes d'actionnement actives (37ᵢ) sont disposées de manière fixe sur une structure porteuse (39).

13. Dispositif de déplacement (31) selon l'une des revendications 8 à 12, **caractérisé en ce que** la structure d'électrodes comprend des électrodes de capteur (47, 48) qui sont disposées dans le même plan que les électrodes d'actionnement actives (37ᵢ).

14. Dispositif de déplacement (31) selon l'une des revendications 8 à 13, **caractérisé en ce qu'**au moins certaines des électrodes d'actionnement actives (37ᵢ) servent simultanément d'électrodes de capteur (47, 48).

15. Composant optique (30) comprenant
15.1. au moins un micromiroir (20) présentant deux degrés de liberté de pivotement, et
15.2. un dispositif de déplacement (31) selon l'une des revendications 8 à 14 pour déplacer ledit au moins un micromiroir (20), ou un dispositif capteur selon l'une des revendications 1 à 7.

16. Composant optique (30) selon la revendication 15, **caractérisé en ce que** ledit au moins un micromiroir (20) est monté au moyen d'une articulation (32) présentant au moins deux degrés de liberté d'inclinaison.

17. Composant optique (30) selon la revendication 16, **caractérisé en ce que** le micromiroir (20) présente un centre de gravité dont la position coïncide précisément avec un point de pivotement effectif défini par l'articulation (32).

18. Réseau de miroirs (19) comprenant une pluralité de composants optiques (30) selon l'une des revendications 15 à 17.

19. Optique d'éclairage (4) pour une installation d'exposition par projection (1) pour guider un rayonnement d'éclairage (10) vers un champ objet (5), comprenant au moins un réseau de miroirs (19) selon la revendication 18.

20. Système d'éclairage (2) pour une installation d'exposition par projection (1), comprenant
20.1. une optique d'éclairage (4) selon la revendication 19, et
20.2. une source de rayonnement (3).

21. Installation d'exposition par projection (1) destinée à la microlithographie, comprenant
21.1. une optique d'éclairage (4) selon la revendication 19, et
21.2. une optique de projection (7) pour projeter dans un champ image (8) un réticule disposé dans un champ objet (5).
